(19)

**Europäisches Patentamt**
**European Patent Office**
**Office européen des brevets**

(11) **EP 4 719 023 A2**

(12) # EUROPEAN PATENT APPLICATION

(43) Date of publication:
**01.04.2026 Bulletin 2026/14**

(21) Application number: **26152274.2**

(22) Date of filing: **03.03.2022**

(51) International Patent Classification (IPC):
***H10N 30/00*** *(2023.01)*

(52) Cooperative Patent Classification (CPC):
**C04B 35/495; C04B 35/62635; C04B 35/62675;**
**C04B 35/645; C23C 14/08; C23C 14/088;**
**C23C 14/34; C23C 14/3414; H10N 30/074;**
**H10N 30/076; H10N 30/704; H10N 30/8542;**
C04B 2235/3201; C04B 2235/3251;
C04B 2235/3255; (Cont.)

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **20.04.2021 JP 2021071067**

(62) Document number(s) of the earlier application(s) in
accordance with Art. 76 EPC:
**22791376.1 / 4 328 987**

(71) Applicant: **Sumitomo Chemical Co., Ltd.**
**Tokyo 103-6020 (JP)**

(72) Inventors:
• **Kuroda, Toshiaki**
**Hitachi-shi, Ibaraki, 319-1418 (JP)**

• **Shibata, Kenji**
**Hitachi-shi, Ibaraki, 319-1418 (JP)**
• **Watanabe, Kazutoshi**
**Hitachi-shi, Ibaraki, 319-1418 (JP)**
• **Kimura, Takeshi**
**Hitachi-shi, Ibaraki, 319-1418 (JP)**

(74) Representative: **Vossius & Partner**
**Patentanwälte Rechtsanwälte mbB**
**Siebertstraße 3**
**81675 München (DE)**

Remarks:
This application was filed on 16.01.2026 as a
divisional application to the application mentioned
under INID code 62.

(54) **PIEZOELECTRIC LAMINATE, PRODUCTION METHOD FOR PIEZOELECTRIC LAMINATE, SPUTTERING TARGET MATERIAL, AND PRODUCTION METHOD FOR SPUTTERING TARGET MATERIAL**

(57) The present invention relates to a piezoelectric stack comprising a substrate having a main surface with a diameter of 3 inches or more; and a piezoelectric film on the substrate, comprising a perovskite-type alkali niobium oxide containing potassium, sodium, niobium, and oxygen, wherein a half-value width of an X-ray rocking curve of (001) is within a range of 0.5° or more and 2.5° or less over an entire area of an inside of a main surface of the piezoelectric film excluding its periphery when performing X-ray diffraction measurement on the piezoelectric film.

(Cont. next page)

(52) Cooperative Patent Classification (CPC): (Cont.)
C04B 2235/3262; C04B 2235/3281;
C04B 2235/6567; C04B 2235/6585;
C04B 2235/663; C04B 2235/95

**Description**

TECHNICAL FIELD

The present disclosure relates to a piezoelectric stack, a method of manufacturing a piezoelectric stack, a sputtering target material, and a method of manufacturing a sputtering target material.

DESCRIPTION OF RELATED ART

Piezoelectric materials are widely utilized in functional electronic components such as sensors and actuators. Piezoelectric materials containing potassium, sodium, niobium, and oxygen are proposed, and a stack (hereinafter referred to as a piezoelectric stack) including a piezoelectric film (KNN-film) deposited using such a piezoelectric material by a sputtering method is also proposed (see, e.g., Patent Document 1).

PRIOR ART DOCUMENT

PATENT DOCUMENT

Patent Document 1: Japanese Patent Laid Open Publication No. 2011-146623

SUMMARY

PROBLEM TO BE SOLVED BY DISCLOSURE

Patent Document 1 discloses that a half-value width of an X-ray rocking curve of (001) when performing X-ray diffraction measurement on the KNN-film falls within a range of 0.5° or more and 2.5° or less by controlling a strength of a magnetic field on a surface to be exposed to plasma of a target material that is used when depositing the KNN-film on a substrate by a sputtering method, or by controlling orientations of crystals constituting a film to be a base of the KNN-film. Patent Document 1 also discloses that the KNN-film is sputter-deposited while causing the substrate to rotate and revolve in order to improve an in-plane uniformity of a film quality of the KNN-film.

However, with the technique described in Patent Document 1, it was found that, when the KNN-film is deposited on a large diameter substrate with a diameter of 3 inches or more by the sputtering method with use of a large diameter target material with a diameter of 3 inches or more like that used in mass production, a region (a defective region) where the above-described half-value width is outside the above-described range appears locally in a main surface of the KNN-film. That is, with the technique described in Patent Document 1, it was found that a region of localized deterioration in the film quality (film properties) appears in the main surface of the KNN-film deposited. This is a new problem found for the first time through intensive studies conducted by the inventors.

An object of the present disclosure is to provide a piezoelectric stack including a large diameter piezoelectric film having uniform film quality, and no localized defective region in an entire area of a main surface excluding its periphery, and techniques relating to the piezoelectric stack.

MEANS FOR SOLVING PROBLEM

According to an aspect of the present disclosure, there is provided a piezoelectric stack and techniques related to the piezoelectric stack, the piezoelectric stack including:

a substrate having a main surface with a diameter of 3 inches or more; and
a piezoelectric film on the substrate, comprising a perovskite-type alkali niobium oxide containing potassium, sodium, niobium, and oxygen,
wherein a half-value width of an X-ray rocking curve of (001) is within a range of 0.5° or more and 2.5° or less over an entire area of an inside of a main surface of the piezoelectric film excluding its periphery when performing X-ray diffraction measurement on the piezoelectric film.

ADVANTAGE OF DISCLOSURE

According to the present disclosure, a piezoelectric stack including a large diameter piezoelectric film having uniform film quality, and no localized defective region in an entire area of a main surface excluding its periphery, can be obtained.

## BRIEF DESCRIPTION OF DRAWINGS

FIG. 1 is a view illustrating an example of a cross-sectional structure of a piezoelectric stack according to an embodiment of the present disclosure.

FIG. 2 is a view illustrating a modified example of the cross-sectional structure of the piezoelectric stack according to the embodiment of the present disclosure.

FIG. 3 is a plan view of a main surface of a piezoelectric film, illustrating measurement points of X-ray diffraction measurement. FIG. 4 is a view illustrating an example of a schematic configuration of a piezoelectric device module according to an embodiment of the present disclosure.

FIG. 5 is a view illustrating an example of a schematic configuration of a sputtering target material according to an embodiment of the present disclosure.

FIG. 6 is a schematic view of a molding apparatus used when producing the sputtering target material, and a graph showing a temperature distribution in a processing chamber.

FIG. 7 is a view illustrating a modified example of the cross-sectional structure of the piezoelectric device module according to the embodiment of the present disclosure.

## DETAILED DESCRIPTION OF THE DISCLOSURE

<Finding by the inventors>

It is known that a film quality of a KNN-film deposited on a substrate by a sputtering method is significantly affected by a strength of an electromagnetic field on a surface (hereinafter also referred to as a "sputtering surface"), which is exposed to plasma, of a target material used for the sputtering deposition, and the directions of crystals (orientations of crystals) constituting a film (a base film) to be a base of the KNN-film. In order to improve an in-plane uniformity for the film quality of the KNN-film, the KNN-film is sputter-deposited while causing the substrate to rotate and revolve, for example. However, the inventors found a new problem that, when the KNN-film is deposited on a large diameter substrate with a diameter of 3 inches or more with use of a target material having a large diameter sputtering surface with a diameter of 3 inches or more like that used in mass production, a defective region having more localized deterioration in the film quality compared with the surrounding region inevitably appears on a main surface of the KNN-film even when adjusting (controlling) the strength of an electromagnetic field on the sputtering surface or the orientations of crystals constituting the base film, or even when performing the sputtering deposition while causing the substrate to rotate and revolve. The defective region referred to here is, for example, a localized region where a half-value width of an X-ray rocking curve of (001) (hereinafter referred to as FWHM (001)) when performing X-ray diffraction measurement on the KNN-film is not within the range of 0.5° or more and 2.5° or less.

The inventors conducted intensive studies on the above-described problem. As a result, the inventors found that, in the target material having a large diameter sputtering surface, the above-described defective region appears in the main surface of the KNN-film deposited on the substrate because the sputtering surface includes a localized region where crystals are not oriented randomly, and abnormal discharging occurs in such a region during sputtering deposition. The "region where crystals are not oriented randomly" can also be referred to be a region where a randomness of the orientation of the crystals is deteriorated, and specifically, is referred to a region where a ratio R of an X-ray diffraction peak intensity from (110) with respect to an X-ray diffraction peak intensity from (001) is not within a range of 0.3 or more and 5 or less when performing X-ray diffraction measurement on the sputtering surface.

The inventors conducted intensive studies on a mechanism by which the "region where crystals are not oriented randomly" locally appears in the sputtering surface of the target material. A target material of KNN can be produced by, for example, compression-molding a mixture obtained by mixing powder comprising a potassium (K) compound (also referred to as "K-compound"), powder comprising a sodium (Na) compound (also referred to as "Na-compound"), and powder comprising a niobium (Nb) compound (also referred to as "Nb-compound") to obtain a molding, and sintering the obtained molding. However, even when a temperature control is attempted when sintering the molding such that a temperature within a front surface (a surface to be a sputtering surface) of the molding is made uniform, it is difficult to make the temperature completely uniform over the front surface of the molding. Particularly, it is actually very difficult to make the temperature within the front surface of the molding completely uniform when producing a target material having a sputtering surface with a diameter of 3 inches or more. When there is a temperature gradient (temperature variation) greater than a predetermined critical value in the front surface of the molding during sintering, that is, when the temperature within the front surface of the molding is not completely uniform during sintering, crystals (crystal grains) are likely to grow in a creeping direction of the front surface of the molding along the temperature gradient in a region where the temperature gradient is large, when compared with a region where the temperature gradient is small. Consequently, when the front surface (the sputtering surface) of the molding after sintering is viewed from above in a vertical direction, there is a region where crystals (e.g., crystal grains with a diameter exceeding 30 $\mu$m) that have grown large in the creeping direction are locally present, and crystals in that region are not oriented randomly (exposed surfaces of the large grown crystals have a large influence) when compared with other regions (regions where a large number of crystals with a diameter of less than 30 $\mu$m are densely packed). Thus, a localized deterioration occurs in the randomness of the orientation of crystals in the sputtering surface of the target material.

The inventors conducted intensive studies on a method of avoiding the phenomenon in which the localized deterioration occurs in the randomness of the orientation of crystals in the sputtering surface of the target material. As a result, the inventors found that, by intentionally generating a temperature gradient in a thickness direction of the molding during sintering of the molding, a crystal growth in the creeping direction of the front surface of the molding can be suppressed even when there is temperature variation on the front surface of the molding, and consequently, a localized deterioration in the randomness of the orientation of crystals on the sputtering surface, can be avoided.

The present disclosure is based on the above-described findings and problem obtained by the inventors.

<Embodiment of the Present Disclosure>

Hereinafter, an embodiment of the present disclosure will be described with reference to the drawings.

(1) Configuration of piezoelectric stack

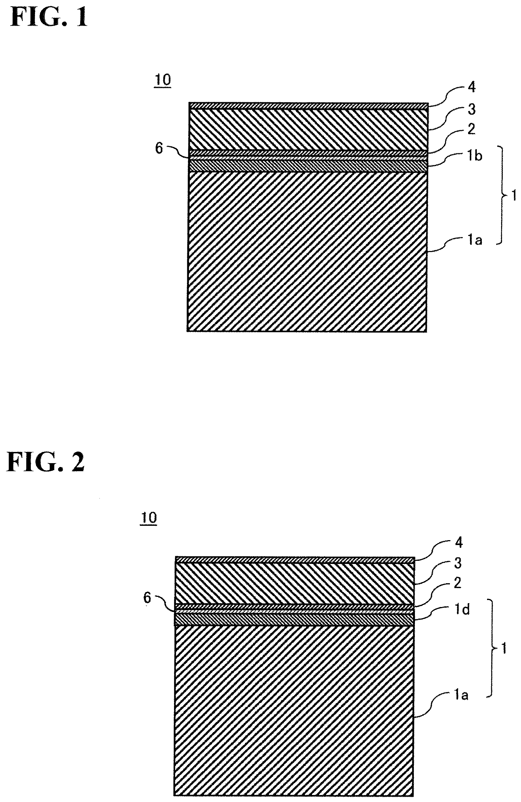

As illustrated in FIG. 1, a stack 10 (hereinafter also referred to as a piezoelectric stack 10) including a piezoelectric film according to the present embodiment includes a substrate 1, a bottom electrode film 2 on the substrate 1, a piezoelectric film (piezoelectric thin film) 3 on the bottom electrode film 2, and a top electrode film 4 on the piezoelectric film 3. In this embodiment, a description will be given, as an example, of a case where one stack structure (a structure comprising a stack of at least the bottom electrode film 2, the piezoelectric film 3, and the top electrode film 4) is provided on one substrate 1.

The substrate 1 has a main surface with a diameter of 3 inches or more. The substrate 1 has a circular external shape in a plan view. The external shape of the substrate 1 (the shape of the main surface of the substrate 1 in a plan view) may be various shapes other than a circular shape, such as an elliptical shape, a rectangular shape, or a polygonal shape. In this case, the substrate 1 preferably has a main surface in which an inscribed circle has a diameter of 3 inches or more. The substrate 1 can be suitably a monocrystalline silicon (Si) substrate 1a on which a surface oxide film ($SiO_2$-film) 1b such as a thermal oxide film or chemical vapor deposition (CVD) oxide film is formed, i.e., a Si-substrate having a surface oxide film. Alternatively, as illustrated in FIG. 2, the substrate 1 can be a Si-substrate 1a having an insulating film 1d formed on a surface thereof, the insulating film 1d comprising an insulating material other than $SiO_2$. Alternatively, the substrate 1 can be a Si-substrate 1a in which Si-(100), Si-(111), or the like is exposed on the surface thereof, i.e., a Si-substrate not having the surface oxide film 1b or insulating film 1d. The substrate 1 can also be an SOI (Silicon On Insulator) substrate, a quartz glass ($SiO_2$) substrate, a gallium arsenide (GaAs) substrate, a sapphire ($Al_2O_3$) substrate, or a metal substrate comprising a metal material such as stainless steel (SUS). The monocrystalline Si-substrate 1a can have a thickness of, for example, 300 $\mu$m or more and 1000 $\mu$m or less, and the surface oxide film 1b can have a thickness of, for example, 1 nm or more and 4000 nm or less.

The bottom electrode film 2 can be deposited using, for example, platinum (Pt). The bottom electrode film 2 is a polycrystalline film. Hereinafter, a polycrystalline film deposited using Pt will also be referred to as a Pt-film. Preferably, the Pt-film has (111) parallel to the main surface of the substrate 1 (including a case where (111) is inclined at an angle within $\pm 5°$ to the main surface of the substrate 1), i.e., the Pt-film is oriented in (111) direction. The meaning of "the Pt-film is oriented in (111) direction" is that peaks other than a peak due to (111) are not observed in an X-ray diffraction pattern obtained by X-ray diffraction (XRD) measurement. As described above, a main surface of the bottom electrode film 2 (a surface to be a base of the piezoelectric film 3) is preferably composed of Pt-(111). The bottom electrode film 2 can be deposited by the sputtering method, an evaporation method, or the like. The bottom electrode film 2 can also be deposited using, in place of Pt, various metals such as gold (Au), ruthenium (Ru), or iridium (Ir); alloys comprising these metals as main components; metal oxides such as strontium ruthenium oxide ($SrRuO_3$, abbreviated as SRO) or lanthanum nickel oxide ($LaNiO_3$, abbreviated as LNO); or the like. The bottom electrode film 2 can be a monolayer film deposited using the above-described various metals, metal oxides, or the like. The bottom electrode film 2 can also be a stack including a Pt-film and a film comprising SRO provided on the Pt-film, a stack including a Pt-film and a film comprising LNO provided on the Pt-film, or the like. An adhesion layer 6 mainly comprising, for example, titanium (Ti), tantalum (Ta), titanium oxide ($TiO_2$), nickel (Ni), ruthenium oxide ($RuO_2$), iridium oxide ($IrO_2$), zinc oxide (ZnO), or the like may also be provided between the substrate 1 and the bottom electrode film 2 in order to enhance adhesion between them. The adhesion layer 6 can be deposited by a method such as the sputtering method or the evaporation method. The bottom electrode film 2 can have a thickness (when the bottom electrode film 2 is a stack, a total thickness of respective layers) of, for example, 100 nm or more and 400 nm or less, and the adhesion layer 6 can have a thickness of, for example, 1 nm or more and 200 nm or less.

The piezoelectric film 3 is a film comprising an alkali niobium oxide containing, for example, potassium (K), sodium (Na), niobium (Nb), and oxygen (O). The piezoelectric film 3 can be deposited using an alkali niobium oxide represented by a composition formula $(K_{1-x}Na_x)NbO_3$, i.e., a potassium sodium niobium oxide (KNN). The coefficient x [= Na/(K + Na)] in the above composition formula can be in a range of 0 < x < 1, preferably $0.4 \leq x \leq 0.7$. The piezoelectric film 3 is a polycrystalline film of KNN (hereinafter also referred to as the KNN-film 3). A crystal structure of KNN is a perovskite structure. In other words, the KNN-film 3 has the perovskite-type. Half or more crystals in a crystal group constituting the KNN-film 3 preferably have a columnar structure. In this specification, the crystal system of KNN is deemed to be a tetragonal crystal system. The KNN-film 3 can be deposited by a method such as the sputtering method. The KNN-film 3 can have a thickness of, for example, 0.5 $\mu$m or more and 5 $\mu$m or less.

The KNN-film 3 can contain one or more elements (dopants) selected from a group consisting of lithium (Li), magnesium (Mg), calcium (Ca), strontium (Sr), barium (Ba), bismuth (Bi), antimony (Sb), vanadium (V), indium (In), Ta, molybdenum (Mo), tungsten (W), chromium (Cr), Ti, zirconium (Zr), hafnium (Hf), scandium (Sc), yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), lutetium (Lu), copper (Cu), zinc (Zn), silver (Ag), manganese (Mn), iron (Fe), cobalt (Co), Ni, aluminum (Al), Si, germanium (Ge), tin (Sn), and gallium (Ga). A concentration of these elements in the KNN-film 3 can be, for example, 5 at% or less (when a plurality of above-described elements are contained, a total concentration of the elements can be 5 at% or less).

Preferably, crystals constituting the KNN-film 3 are preferentially oriented in (001) direction to the main surface of the substrate 1 (or the Si-substrate 1a when the substrate 1 is, for example, the Si-substrate 1a having the surface oxide film 1b or insulating film 1d). That is, a main surface of the KNN-film 3 (a surface to be a base of the top electrode film 4) is preferably mainly composed of KNN-(001). For example, by depositing the KNN-film 3 directly on the Pt-film (bottom electrode film 2) whose main surface is mainly composed of Pt-(111), the KNN-film 3 whose main surface is mainly composed of KNN-(001) can be easily obtained.

In this specification, the meaning of "crystals constituting the KNN-film 3 are oriented in (001) direction" is that (001) of the crystals constituting the KNN-film 3 are parallel or substantially parallel to the main surface of the substrate 1. The meaning of "crystals constituting the KNN-film 3 are preferentially oriented in (001) direction" is that there are many crystals in which (001) are parallel or substantially parallel to the main surface of the substrate 1. For example, 80 % or more crystals in the crystal group constituting the KNN-film 3 are preferably oriented in (001) direction to the main surface of the substrate 1. That is, a (001) orientation percentage of the crystals constituting the KNN-film 3 is preferably, for example, 80 % or more, and more preferably 90 % or more. The "orientation percentage" in this specification is a value calculated using the following (Math. 1) based on peak intensities of an X-ray diffraction pattern $(2\theta/\theta)$ obtained by performing XRD measurement on the KNN-film 3.

(Math. 1) Orientation percentage (%) = {(001) peak intensity / ((001) peak intensity + (110) peak intensity)} $\times$ 100

The "(001) peak intensity" in the above (Math. 1) is the intensity of a diffraction peak due to crystals oriented in (001) direction (i.e., crystals whose (001) is parallel to the main surface of the substrate 1) among crystals constituting the KNN-film 3 in the X-ray diffraction pattern obtained by performing XRD measurement on the KNN-film 3, and is the intensity of a peak that appears within a range that 2θ is 20° or more and 23° or less. When a plurality of peaks appear within the range that 2θ is 20° or more and 23° or less, the "(001) peak intensity" is the intensity of the highest peak. The "(110) peak intensity" in the above (Math. 1) is the intensity of a diffraction peak due to crystals oriented in (110) direction (i.e., crystals whose (110) is parallel to the main surface of the substrate 1) among the crystals constituting the KNN-film 3 in the X-ray diffraction pattern obtained by performing XRD measurement on the KNN-film 3, and is the intensity of a peak that appears within a range that 2θ is 30° or more and 33° or less. When a plurality of peaks appear within the range that 2θ is 30° or more and 33° or less, the "(110) peak intensity" is the intensity of the highest peak.

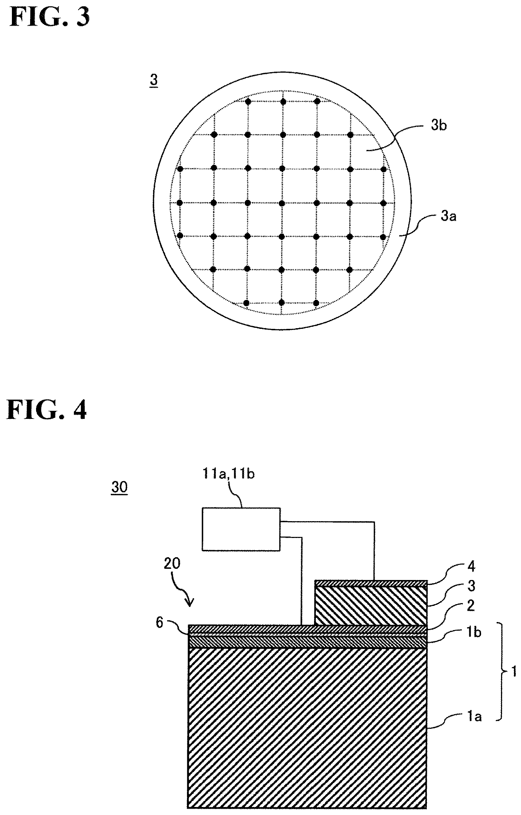

The KNN-film 3 has a main surface (a top surface) with a diameter of 3 inches or more, i.e., a large diameter main surface. The KNN-film 3 does not have a localized defective region over an entire area of an inside of the main surface of the KNN-film 3 excluding its periphery, and has uniform film quality. Specifically, a half-value width of an X-ray rocking curve of (001) (FWHM (001)) is within a range of 0.5° or more and 2.5° or less over an entire area of the inside of the main surface of the KNN-film 3 excluding its periphery when performing XRD measurement on the KNN-film 3. Here, the meaning of "FWHM (001) is within the range of 0.5° or more and 2.5° or less over the entire area of the inside of the main surface of the KNN-film 3 excluding its periphery" is that, when XRD measurement is performed at measurement points set at 1 cm intervals in a grid in a region 3b of an inside of an outer peripheral region 3a having a width of 5 mm from an edge of the main surface (i.e., in a region excluding the outer peripheral region 3a having a width of 5 mm from the edge) of the KNN-film 3 as illustrated in FIG. 3, FWHM (001) is within the range of 0.5° or more and 2.5° or less at all the measurement points. In FIG. 3, the measurement points of FWHM (001) are illustrated by black circles. Hereinafter, "over the entire area of the inside of the main surface of the KNN-film 3 excluding its periphery" will also be described as "over the entire area of the main surface of the KNN-film 3".

Since FWHM (001) is within the range of 0.5° or more and 2.5° or less over the entire area of the main surface of the KNN-film 3, the KNN-film 3 can have uniform (in-plane uniform) film properties over the entire area of the main surface of the KNN-film 3. Therefore, an occurrence of variation in properties can be avoided among a plurality of later-described piezoelectric elements 20 (piezoelectric device modules 30) obtained from the single piezoelectric stack 10. Consequently, the yield and reliability of the piezoelectric elements 20 (piezoelectric device modules 30) can be improved.

The top electrode film 4 can be deposited, for example, using various metals such as Pt, Au, Al, or Cu, or an alloy comprising these various metals. The top electrode film 4 can be deposited by a method such as the sputtering method, the evaporation method, a plating method, or a metal paste method. The top electrode film 4 does not significantly affect the crystal structure of the KNN-film 3, unlike the bottom electrode film 2. Therefore, there is no particular limitation on the material, the crystal structure, and the deposition method of the top electrode film 4. An adhesion layer mainly comprising, for example, Ti, Ta, $TiO_2$, Ni, $RuO_2$, $IrO_2$, or the like may also be provided between the KNN-film 3 and the top electrode film 4 in order to enhance adhesion between them. The top electrode film 4 can have a thickness of, for example, 100 nm or more and 5000 nm or less. When the adhesion layer is provided, the adhesion layer can have a thickness of, for example, 1 nm or more and 200 nm or less.

(2) Configuration of piezoelectric device module

FIG. 4 illustrates a schematic configuration view of a device module 30 (hereinafter also referred to as a piezoelectric device module 30) including the KNN-film 3. By forming the above-described piezoelectric stack 10 into a predetermined shape, an element (device) 20 (an element 20 including the KNN-film 3, hereinafter also referred to as the piezoelectric element 20) is obtained as illustrated in FIG. 4. The piezoelectric device module 30 includes at least the piezoelectric element 20, and a voltage applicator 11a or a voltage detector 11b connected to the piezoelectric element 20. The voltage applicator 11a is a means that applies a voltage between the bottom electrode film 2 and the top electrode film 4, and the voltage detector 11b is a means that detects a voltage generated between the bottom electrode film 2 and the top electrode film 4. Various known means can be used as the voltage applicator 11a and the voltage detector 11b.

By connecting the voltage applicator 11a between the bottom electrode film 2 and the top electrode film 4 of the piezoelectric element 20, the piezoelectric device module 30 can function as an actuator. The KNN-film 3 can be deformed by applying a voltage between the bottom electrode film 2 and the top electrode film 4 using the voltage applicator 11a. Various components connected to the piezoelectric device module 30 can be actuated due to this deformation action. In this case, examples of applications of the piezoelectric device module 30 include heads for inkjet printers, MEMS mirrors for scanners, vibrators for ultrasonic generators, and the like.

By connecting the voltage detector 11b between the bottom electrode film 2 and the top electrode film 4 of the piezoelectric element 20, the piezoelectric device module 30 can function as a sensor. When the KNN-film 3 deforms due to a change in physical quantity of some kind, the deformation generates a voltage between the bottom electrode film 2 and the top electrode film 4. The magnitude of the physical quantity applied to the KNN-film 3 can be measured by detecting the voltage using the voltage detector 11b. In this case, examples of applications of the piezoelectric device module 30 include angular velocity sensors, ultrasonic sensors, pressure sensors, acceleration sensors, and the like.

The piezoelectric device module 30 (the piezoelectric element 20) is produced from the piezoelectric stack 10 including the KNN-film 3 having FWHM (001) within the range of 0.5° or more and 2.5° or less over the entire area of the main surface. Accordingly, the occurrence of variation in properties can be avoided among a plurality of piezoelectric elements 20 (piezoelectric device modules 30) obtained from the single piezoelectric stack 10. That is, a plurality of piezoelectric elements 20 (piezoelectric device modules 30) whose properties are uniform can be obtained from the single piezoelectric stack 10.

For example, in a plurality of piezoelectric device modules 30 obtained by processing a single piezoelectric stack 10 including a Ti-layer (thickness: 2 nm) as the adhesion layer 6, a Pt-film (thickness: 200 nm) as the bottom electrode film 2, the KNN-film 3 (thickness: 2 $\mu$m), a $RuO_2$-layer (thickness: 30 nm) as an adhesion layer that increases adhesion between the KNN-film 3 and the top electrode film 4, and a Pt-film (thickness: 100 nm) as the top electrode film 4, which are provided in this order on the large diameter substrate 1, all the piezoelectric device modules 30 can have a piezoelectric constant $-e_{31}$ of 10 $C/m^2$ or more when applying an electric field of -100 kV/cm between the bottom electrode film 2 and the top electrode film 4. Also, for example, in the above-described plurality of piezoelectric device modules 30, all the piezoelectric device modules 30 can have a leak current density of $1 \times 10^{-5}$ $A/cm^2$ or less when applying an electric field of -150 kV/cm between the bottom electrode film 2 and the top electrode film 4. In this specification, the meaning of "an electric field of -100 kV/cm or -150 kV/cm is applied between the bottom electrode film 2 and the top electrode film 4" is that a negative voltage is applied to the top electrode film 4 in such a manner that an electric field of 100 kV/cm or 150 kV/cm is generated between the top electrode film 4 and the bottom electrode film 2 in an upward direction (a direction from the bottom electrode film 2 to the top electrode film 4) in a thickness direction of the KNN-film 3, with the top electrode film 4 side being at a negative potential and the bottom electrode film 2 side being grounded.

As described above, the plurality of piezoelectric elements 20 (piezoelectric device modules 30) have uniform properties, and accordingly, the yield and reliability of the piezoelectric elements 20 (piezoelectric device modules 30) can be improved.

(3) Method of manufacturing piezoelectric stack, piezoelectric element, and piezoelectric device module

A method of manufacturing the piezoelectric stack 10, the piezoelectric element 20, and the piezoelectric device module 30 will be described.

(Deposition of adhesion layer and bottom electrode film)

The large diameter substrate 1 whose main surfaces has a diameter of 3 inches or more is firstly prepared, and the adhesion layer 6 (e.g., a Ti-layer) and the bottom electrode film 2 (e.g., a Pt-film) are deposited in this order on any one of the main surfaces of the substrate 1 by, for example, the sputtering method. It is also acceptable to prepare the substrate 1 on which the adhesion layer 6 and/or the bottom electrode film 2 are deposited in advance on any one of the main surfaces of the substrate 1.

The following conditions are exemplified as the conditions for providing the adhesion layer 6.

Temperature (substrate temperature): 100 °C or higher and 500 °C or lower, preferably 200 °C or higher and 400 °C or lower
RF-power: 1000 W or more and 1500 W or less, preferably 1100 W or more and 1300 W or less
Atmosphere: Argon (Ar) gas atmosphere
Atmosphere pressure: 0.1 Pa or more and 0.5 Pa or less, preferably 0.2 Pa or more and 0.4 Pa or less
Time: 30 seconds or more and 3 minutes or less, preferably 45 seconds or more and 2 minutes or less

The following conditions are exemplified as the conditions for depositing the bottom electrode film 2.

Temperature (substrate temperature): 100 °C or higher and 500 °C or lower, preferably 200 °C or higher and 400 °C or lower
RF-power: 1000 W or more and 1500 W or less, preferably 1100 W or more and 1300 W or less
Atmosphere: Ar-gas atmosphere
Atmosphere pressure: 0.1 Pa or more and 0.5 Pa or less, preferably 0.2 Pa or more and 0.4 Pa or less
Time: 3 minutes or more and 10 minutes or less, preferably 4 minutes or more and 8 minutes or less, more preferably 5 minutes or more and 6 minutes or less

(Deposition of KNN-film)

After the depositions of the adhesion layer 6 and the bottom electrode film 2 are finished, the KNN-film 3 is subsequently deposited on the bottom electrode film 2 by, for example, the sputtering method such as a RF magnetron sputtering method. In this event, a later-described target material 100 comprising a sintered ceramics of a perovskite-type alkali niobium oxide containing K, Na, Nb, and O is used. The target material 100 has 3 inches or more diameter of a sputtering surface 101 in which crystals are oriented randomly over an entire area of an inside of the sputtering surface 101 excluding its periphery. Details of the target material 100 will be described later. A composition ratio of the KNN-film 3 can be adjusted by controlling a composition of the target material 100, for example.

The following conditions are exemplified as the conditions for depositing the KNN-film 3. A deposition time can be appropriately set depending on the thickness of the KNN-film 3.

RF-power: 2000 W or more and 2400 W or less, preferably 2100 W or more and 2300 W or less
Atmosphere: mixed gas atmosphere of Ar-gas and oxygen ($O_2$) gas
Atmosphere pressure: 0.2 Pa or more and 0.5 Pa or less, preferably 0.2 Pa or more and 0.4 Pa or less
Partial pressure of Ar-gas relative to $O_2$-gas (Ar/$O_2$-partial pressure ratio): 30/1 to 20/1, preferably 27/1 to 22/1
Deposition temperature: 500 °C or higher and 700 °C or lower, preferably 550 °C or higher and 650 °C or lower
Deposition rate: 0.5 $\mu$m/hr or higher and 2 $\mu$m/hr or lower, preferably 0.5 $\mu$m/hr or higher and 1.5 $\mu$m/hr or lower

By depositing the KNN-film 3 under the above-described conditions using the later-described target material 100 having the sputtering surface 101 in which crystals are oriented randomly over the entire area of the inside thereof excluding its periphery, an occurrence of abnormal discharging can be avoided over an entire area of the sputtering surface during sputtering deposition. Consequently, an appearance of the localized defective region on the main surface of the KNN-film 3 can be avoided even when the large diameter KNN-film 3 is deposited on the large diameter substrate 1 (or on the large diameter bottom electrode film 2 deposited on the large diameter substrate 1). That is, the large diameter KNN-film 3 having uniform film quality over the entire area of its main surface can be obtained. Specifically, the large diameter KNN-film 3 having FWHM (001) within the range of 0.5° or more and 2.5° or less over the entire area of its main surface, can be obtained.

(Deposition of top electrode film)

After the deposition of the KNN-film 3 is finished, the top electrode film 4 is deposited on the KNN-film 3 by, for example, the sputtering method. Conditions for depositing the top electrode film 4 can be similar to the above-described conditions for depositing the bottom electrode film 2. Thus, the piezoelectric stack 10 is obtained as illustrated in FIG. 1.

(Production of piezoelectric element and piezoelectric device module)

Subsequently, the obtained piezoelectric stack 10 is formed into a predetermined shape (is subjected to fine processing into the predetermined pattern) by etching or the like. Thus, the piezoelectric element 20 is obtained as illustrated in FIG. 4, and the piezoelectric device module 30 is obtained by connecting the voltage applicator 11a or the voltage detector 11b to the piezoelectric element 20. An etching method can be, for example, a dry etching method such as reactive ion etching or a wet etching method using a predetermined etchant.

When the piezoelectric stack 10 is to be formed by dry etching, a photoresist pattern as an etching mask for dry etching is formed on the piezoelectric stack 10 (e.g., the top electrode film 4) by a photolithography process or the like. A noble metal film (a metal mask) such as a Cr-film, a Ni-film, a Pt-film, or a Ti-film may be formed as the etching mask by the sputtering method. Then, dry etching is performed on the piezoelectric stack 10 (the top electrode film 4, the KNN-film 3, and the like) using a gas containing a halogen element as an etching gas. Examples of the halogen element include chlorine (Cl), fluorine (F), or the like. $BCl_3$-gas, $SiCl_4$-gas, $Cl_2$-gas, $CF_4$-gas, $C_4F_8$-gas, or the like can be used as the gas containing a halogen element.

When the piezoelectric stack 10 is to be formed by wet etching, a silicon oxide ($SiO_x$) film or the like as an etching mask for wet etching is formed on the piezoelectric stack 10 (e.g., the top electrode film 4). Then, wet etching is performed on the piezoelectric stack 10 (the top electrode film 4, the KNN-film 3, and the like) by immersing the piezoelectric stack 10 in an etchant containing an alkaline aqueous solution of a chelating agent and not containing hydrofluoric acid, for example. An etchant obtained by mixing ethylenediaminetetraacetic acid as the chelating agent, aqueous ammonia, and hydrogen peroxide solution can be used as the etchant containing the alkaline aqueous solution of the chelating agent and not containing hydrofluoric acid.

(4) Configuration of target material

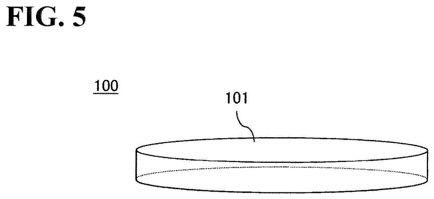

Hereinafter, a configuration of a sputtering target material 100 that is used when depositing the KNN-film 3 by sputtering, will be described in detail, with reference to FIG. 5. The target material 100 is fixed to a backing plate via an indium-based adhesive or the like, and then attached to a sputtering apparatus in such a manner that the sputtering surface 101 is irradiated with plasma, for example. As described above, the "sputtering surface" is a surface to be exposed to plasma during the sputtering deposition (a surface in which ions collide during the sputtering deposition) out of surfaces of the target material 100.

FIG. 5 is a schematic configuration view illustrating an example of the target material 100 according to the present embodiment. In FIG. 5, the target material 100 is illustrated with the sputtering surface 101 facing upward.

The target material 100 is composed of a sintered ceramics of a perovskite-type alkali niobium oxide containing K, Na, Nb, and O, i.e., a KNN-sintered ceramics. The target material 100 has a composition within a range of $0 < Na/(K+Na) < 1$, preferably $0.4 \leq Na/(K+Na) \leq 0.7$. The target material 100 comprises a plurality of KNN-crystal grains.

The target material 100 may contain one or more elements selected from a group consisting of Li, Mg, Ca, Sr, Ba, Bi, Sb, V, In, Ta, Mo, W, Cr, Ti, Zr, Hf, Sc, Y, La, Ce, Pr, Nd, Sm, Eu, Gd, Tb, Dy, Ho, Er, Tm, Yb, Lu, Cu, Zn, Ag, Mn, Fe, Co, Ni, Al, Si, Ge, Sn, and Ga, as dopants. A concentration of these elements in the target material 100 can be, for example, 5 at% or less (when a plurality of elements are contained, a total concentration of the elements can be 5 at% or less).

The target material 100 has a circular external shape. That is, the target material 100 has the sputtering surface 101 having a circular shape in a plan view. The sputtering surface 101 can have a diameter of, for example, 3 inches or more. The external shape of the target material 100 (the shape of the sputtering surface 101 in a plan view) may be various shapes other than a circular shape, such as an elliptical shape, a rectangular shape, or a polygonal shape. In this case, an inscribed circle in the sputtering surface 101 can have a diameter of, for example, 3 inches or more. As described above, the target material 100 has the sputtering surface 101 with a diameter of 3 inches or more, i.e., the large diameter sputtering surface 101.

The target material 100 is configured in such a manner that a ratio R of a (110) peak intensity with respect to a (001) peak intensity (R = (110) peak intensity / (001) peak intensity) is within a range of 0.3 or more and 5 or less, preferably 1.2 or more and 5 or less, and more preferably 1.2 or more and 3 or less over an entire area of an inside of the sputtering surface 101 excluding its periphery when performing XRD measurement on the sputtering surface 101.

The "(001) peak intensity" referred to here is an X-ray diffraction peak intensity from (001) when performing XRD measurement on the sputtering surface 101, i.e., the intensity of a diffraction peak due to crystals oriented in (001) direction among crystals constituting the target material 100 in an X-ray diffraction pattern obtained by performing XRD measurement on the sputtering surface 101, and is the intensity of a peak that appears within a range that 2θ is 20° or more and 23° or less. When a plurality of peaks appear within the range that 2θ is 20° or more and 23° or less, the "(001) peak intensity" is the intensity of the highest peak. Also, the "(110) peak intensity" referred to here is an X-ray diffraction peak intensity from (110) when performing XRD measurement on the sputtering surface 101, i.e., the intensity of a diffraction peak due to crystals oriented in (110) direction among the crystals constituting the target material 100 in the X-ray diffraction pattern obtained by performing XRD measurement on the sputtering surface 101, and is the intensity of a peak that appears within a range that 2θ is 30° or more and 33° or less. When a plurality of peaks appear within the range that 2θ is 30° or more and 33° or less, the "(110) peak intensity" is the intensity of the highest peak.

Also, the meaning of "the ratio R is within the range of 0.3 or more and 5 or less over the entire area of the inside of the sputtering surface 101 excluding its periphery" is that, when XRD measurement is performed at measurement points set at 1 cm intervals in a grid in a region of the sputtering surface 101 excluding its region (periphery) having a width of 5 mm from the edge (i.e., a region of an inside of the region having a width of 5 mm from the edge), the ratio R is 0.3 or more and 5 or less at all the measurement points (37 points in a case where the sputtering surface 101 has a diameter of 3 inches). Hereinafter, "over the entire area of the inside of the sputtering surface 101 excluding its periphery" will also be referred to as "over the entire area of the sputtering surface".

As described above, in the target material 100, even though the sputtering surface 101 has a large diameter, there is no localized region where crystals are not oriented randomly, i.e., there is no region where the randomness of the orientations of crystals is locally deteriorated, and crystals are oriented randomly over the entire area of the sputtering surface. Preferably, in the target material 100, there is no region where crystal grains with a grain size exceeding 30 μm are densely packed is observed in an entire area of the sputtering surface 101, and in an entire area of any arbitrary surface parallel to the sputtering surface 101 (hereinafter also referred to as "in the entire area of surfaces parallel to the sputtering surface 101") excluding peripheries of those surfaces. More preferably, in the target material 100, there is no crystal grains with a grain size exceeding 30 μm are observed in the entire area of the sputtering surface 101 and in the entire area of surfaces parallel to the sputtering surface 101. That is, in the target material 100, the entire area of the sputtering surface 101 and the entire area of surfaces parallel to the sputtering surface 101, is composed of crystal grains with a grain size of, for example, 0.1 μm or more and 30 μm or less, preferably 0.1 μm or more and 20 μm or less, and more preferably 0.1 μm or more and 10 μm or less.

By sputter depositing the KNN-film 3 on the substrate 1 with a diameter of 3 inches or more using such a target material 100, the occurrence of abnormal discharging can be avoided over the entire area of the sputtering surface 101 during the sputtering deposition. Consequently, the large diameter KNN-film 3 having FWHM (001) within the range of 0.5° or more and 2.5° or less over the entire area of the main surface, can be obtained.

The target material 100 has a relative density of 60 % or more, preferably 70 % or more, and more preferably 80 % or more over the entire area of the sputtering surface. The relative density (%) referred to here is a value calculated using the following formula: (measured density / theoretical density of KNN) × 100. The theoretical density of KNN is 4.51 g/cm$^3$. Also, the target material 100 has a flexural strength of 10 MPa or more, preferably 30 MPa or more, more preferably 40 MPa or more, and further preferably 50 MPa or more over the entire area of the sputtering surface. The flexural strength referred to here is a value measured by a three-point bending test (in accordance with JIS R1601:2008). As described above, since the relative density is 60 % or more, or the flexural strength is 10 MPa or more, over the entire area of the sputtering surface, the occurrence of abnormal discharging can be surely avoided over the entire area of the sputtering surface during the sputtering deposition using the target material 100.

Also, the target material 100 preferably has a high resistivity. For example, the target material 100 preferably has a volume resistivity of 1000 kΩcm or more. This allows the KNN-film 3 having good insulating properties to be obtained. An upper limit value of the volume resistivity is not particularly limited, but may be, for example, 100 MΩcm or less.

(5) Method of manufacturing target material

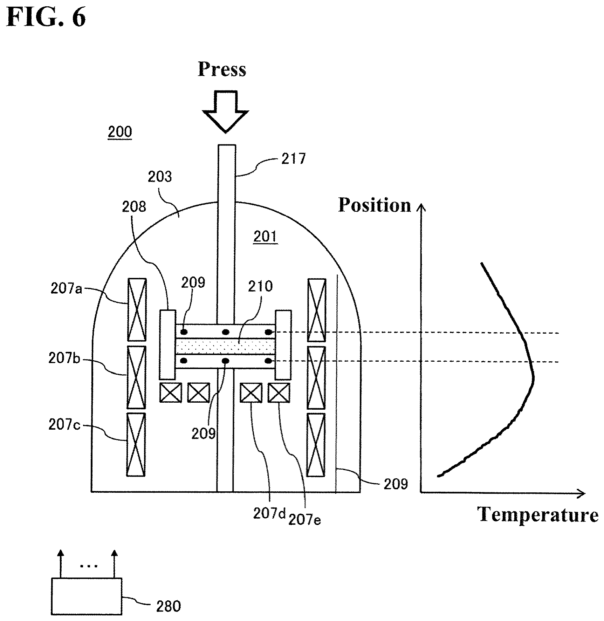

Hereinafter, a method of manufacturing the target material 100 having the ratio R within the range of 0.3 or more and 5 or less over an entire area of the sputtering surface, will be described in detail, with reference to FIG. 6.

In a production sequence of the target material 100 according to the present embodiment, the following processes are performed:

a process (mixing treatment) of obtaining a mixture by mixing powder comprising a K-compound, powder comprising an Na-compound, and powder comprising an Nb-compound, at a predetermined ratio;

a process (compression molding treatment) of molding the mixture by applying a predetermined pressure (load), to obtain a molding with a diameter of 3 inches or more; and

a process (sintering treatment) of obtaining a sintered ceramics by heating and sintering the molding for 1 hour or more and 5 hours or less under a condition where a temperature within a front surface of the molding is 800 °C or higher and 1150 °C or lower over an entire its surface, and under a condition where a temperature gradient increases from the front surface to a rear surface, at a rate of 10 °C/mm or more. In the present embodiment, explanation will be given for a case where the compression molding treatment and the sintering treatment are performed at the same time (together).

It is also acceptable to further perform after the mixing treatment and before the compression molding treatment:

a process (pre-sintering treatment) of heating and pre-sintering the mixture at a temperature lower than a heating temperature in the sintering treatment; and

a process (pulverization treatment) of pulverizing the mixture after pre-sintering. In this case, in the compression molding treatment, a predetermined pressure is applied to the mixture which is pulverized after pre-sintering.

It is also acceptable to further perform a process (heating treatment) of heating the sintered ceramics at a predetermined temperature after the sintering treatment.

(Mixing treatment)

A mixture is obtained by mixing powder comprising the K-compound, powder comprising the Na-compound, and powder comprising the Nb-compound, at a predetermined ratio.

Specifically, the powder comprising the K-compound, the powder comprising the Na-compound, and the powder comprising the Nb-compound are firstly prepared.

The K-compound is at least one selected from a group consisting of oxides of K, complex oxides of K, and compounds (e.g., a carbonic acid salt and an oxalic acid salt) of K which become oxides when heated. For example, a potassium carbonate ($K_2CO_3$) powder can be used as the powder comprising the K-compound.

The Na-compound is at least one selected from a group consisting of oxides of Na, complex oxides of Na, and compounds (e.g., a carbonic acid salt and an oxalic acid salt) of Na which become oxides when heated. For example, a sodium carbonate ($Na_2CO_3$) powder can be used as the powder comprising the Na-compound.

The Nb-compound is at least one selected from a group consisting of oxides of Nb, complex oxides of Nb, and compounds of Nb which become oxides when heated. For example, a niobium oxide ($Nb_2O_5$) powder can be used as the powder comprising the Nb-compound.

When the target material 100 containing a predetermined dopant is to be produced, powder comprising a compound of at least one element selected from the group consisting of Li, Mg, Ca, Sr, Ba, Bi, Sb, V, In, Ta, Mo, W, Cr, Ti, Zr, Hf, Sc, Y, La, Ce, Pr, Nd, Sm, Eu, Gd, Tb, Dy, Ho, Er, Tm, Yb, Lu, Cu, Zn, Ag, Mn, Fe, Co, Ni, Al, Si, Ge, Sn, and Ga is prepared. Powder comprising a compound of each of the above-described elements is at least one selected from a group consisting of powders comprising oxides of the element, powders comprising complex oxides of the element, and powders comprising compounds (e.g., a carbonic acid salt and an oxalic acid salt) of the element which become oxides when heated.

A mixing ratio of each of the above-described powders is adjusted such that the target material 100 has a predetermined composition, and each powder is weighed. Each powder may be weighed in the air, but is preferably weighed in an inert gas atmosphere such as Ar-gas or nitrogen ($N_2$) gas in order to avoid a deviation of a composition ratio of the target material 100. Each powder is preferably weighed after sufficiently dried (dehydrated) in order to surely avoid the deviation of the composition ratio of the target material 100.

Subsequently, the powders are mixed (subjected to wet mixing) using a mixer such as a ball mill or a bead mill. The following conditions are exemplified as the conditions for mixing.

Solvent: organic solvent such as ethanol, or water
Mixing time: 5 hours or more and 30 hours or less, preferably 10 hours or more and 26 hours or less
Mixing atmosphere: air

By mixing the powders under the above-described conditions, an agglomeration of the powders can be avoided. Consequently, the target material 100 can have uniform composition in the entire area of the sputtering surface 101 and in the entire area of the surfaces parallel to the sputtering surface 101.

(Pre-sintering treatment and pulverization treatment)

After the mixing treatment is finished, the mixture obtained in the mixing treatment is heated and pre-sintered at a temperature lower than a heating temperature in the later-described sintering treatment (pre-sintering treatment).

The following conditions are exemplified as the conditions for pre-sintering.

Heating temperature: temperature which is 650 °C or higher and 1100 °C or lower, preferably 700 °C or higher and 900 °C or lower, more preferably 700 °C or higher and lower than 800 °C, and is lower than the heating temperature in the later-described sintering treatment

Heating time: 1 hour or more and 50 hours or less, preferably 5 hours or more and 40 hours or less, more preferably 10 hours or more and 35 hours or less

After the pre-sintering treatment is finished, the mixture after pre-sintering is mixed while being pulverized using a ball mill or the like (pulverization treatment).

The following condition is exemplified as the condition for pulverizing.

Pulverization (mixing) time: 3 hours or more and 10 hours or less, preferably 5 hours or more and 9 hours or less

Other conditions can be similar to the above-described conditions for the mixing treatment.

(Compression molding treatment and sintering treatment)

After the pre-sintering treatment and the pulverization treatment are finished, a compression molding treatment and a sintering treatment are performed at the same time using a molding apparatus 200 illustrated in FIG. 6, for example. The compression molding treatment is a process of molding (compression molding) the mixture, which is obtained by being pulverized and mixed after pre-sintering, by applying a predetermined pressure to the mixture, to obtain the molding. The sintering treatment is a process of obtaining the sintered ceramics by heating and sintering the molding under predetermined conditions. That is, hot press sintering in which the sintering treatment is performed while performing the compression molding treatment, is performed.

The molding apparatus 200 illustrated in FIG. 6 includes a chamber 203 comprising SUS or the like and including a processing chamber 201 therein. A jig (a mold) 208 to be filled with (or to be housed) a mixture 210 is provided in the processing chamber 201. The jig 208 comprises a material such as graphite and is configured to be capable of forming a molding (a sintered ceramics) with a diameter of 3 inches or more. A pressing means 217 (e.g., a hydraulic pressing means 217) configured to be capable of applying a predetermined pressure to the mixture 210 within the jig 208 is provided in the processing chamber 201. Also, a heater 207 that heats the mixture 210 within the jig 208 to a predetermined temperature is provided in the processing chamber 201. The heater 207 includes an upper heater 207a, a middle heater 207b, and a lower heater 207c, which are arranged separately in this order from an upper side toward a lower side in the processing chamber 201, an inside heater 207d that heats an inside zone of the jig 208, and an outside heater 207e that is arranged separately from the inside heater 207d and heats an outside zone of the jig 208. The upper heater 207a, the middle heater 207b, and the lower heater 207c each have a cylindrical shape, the inside heater 207d and the outside heater 207e each have a doughnut shape, and temperatures of the respective heaters can be controlled individually. Also, temperature sensors 209 that measure a temperature inside the processing chamber 201 are provided in the processing chamber 201. Each member included in the molding apparatus 200 is connected to a controller 280 configured as a computer, and later-described procedures and conditions are controlled by a program executed by the controller 280.

The compression molding treatment and the sintering treatment can be performed using the above-described molding apparatus 200 by, for example, the following procedures.

First, the jig 208 is filled with the mixture 210 obtained by being pulverized and mixed after pre-sintering. Then, a predetermined pressure is applied by the pressing means 217 to the mixture 210 within the jig 208 in a direction perpendicular to a pressing surface as illustrated by an outlined arrow in FIG. 6, to form a molding.

The following conditions are exemplified as the conditions for compression molding.

Applied pressure (load): 100 kgf/cm$^2$ or more and 500 kgf/cm$^2$ or less

Pressing time: 1 hour or more and 5 hours or less, preferably 2 hours or more and 4 hours or less

Atmosphere: inert gas atmosphere or vacuum atmosphere

Since the load is 100 kgf/cm$^2$ or more and 500 kgf/cm$^2$ or less when performing the compression molding, a breakage of the jig 208 can be avoided while obtaining the target material 100 having a predetermined mechanical strength. When the load is less than 100 kgf/cm$^2$, the mixture is not sufficiently compressed, and consequently, the obtained sintered ceramics have low mechanical strength in some cases. When the mechanical strength is low, cracks are likely to be generated in the production of the target material 100, and the yield may decrease in some cases. Also, when the target material 100 comprising such a sintered ceramics is used, cracks may be generated in the target material 100 during the deposition of the KNN-film 3 as well, and consequently, various physical properties of the KNN-film 3, such as crystal quality and film thickness may locally deteriorate (change) in some cases. Also, when the load is more than 500 kgf/cm$^2$, the possibility of the breakage of the jig 208 increases.

The molding is heated and sintered under predetermined conditions while performing the compression molding treatment under the above-described conditions.

The sintering treatment is performed by heating the molding (the mixture 210) for 1 hour or more and 5 hours or less under a condition where a temperature (a sintering temperature) within a front surface of the molding (the mixture 210 within the jig 208), is 800 °C or higher and 1150 °C or lower over an entire its surface, and under a condition where a temperature gradient increases from the front surface to a rear surface of the molding, at a rate of 10 °C/mm or more. In this event, the molding (the mixture 210) is heated while controlling temperatures of the heaters 207a to 207c based on temperatures detected by the temperature sensors 209 in such a manner that the temperature inside the processing chamber 201 (the temperature of the molding or the mixture 210) becomes a desired temperature distribution (e.g., in such a manner that temperature distribution inside the processing chamber 201 becomes a temperature distribution shown by the graph in FIG. 6), and controlling temperatures of the heaters 207d and 207e based on temperatures detected by the temperature sensors 209 in such a manner that the temperature within the front surface of the molding becomes uniform. In this specification, the front surface of the molding is a surface to be the sputtering surface 101 of the target material 100, and the rear surface of the molding is opposite to the front surface of the molding.

The following conditions are exemplified as the conditions for sintering.

Sintering temperature: 800 °C or higher and 1150 °C or lower, preferably 900 °C or higher and 1150 °C or lower, more preferably 1000 °C or higher and 1150 °C or lower
Temperature gradient: gradient increases from the front surface to the rear surface of the molding, at the rate of 10 °C/mm or more, preferably 10 °C/mm or more and 15 °C/mm or less
Sintering time (heating time): 1 hour or more and 5 hours or less, preferably 2 hours or more and 3 hours or less

There is no particular limitation on timings at which heating (sintering) is started and ended. Heating may be started at the same time as pressing, or before the start of pressing, or after the start of pressing. Also, heating may be ended at the same time as pressing, or before the end of pressing, or after the end of pressing.

By performing the compressing molding and sintering under the above-described conditions, the large diameter target material 100 in which crystals are oriented randomly over the entire area of the sputtering surface, can be obtained. Specifically, the large diameter sintered ceramics having the above-described ratio R within the range of 0.3 or more and 5 or less over the entire area of the surface to be the sputtering surface 101, can be obtained. Consequently, the large diameter target material 100 having the above-described ratio R within the range of 0.3 or more and 5 or less over the entire area of the sputtering surface, can be obtained.

In particular, by intentionally generating the temperature gradient, which increases from the front surface to the rear surface of the molding, at the rate of 10 °C/mm or more during sintering, the large diameter target material 100 having the ratio R within the range of 0.3 or more and 5 or less over the entire area of the sputtering surface, can be obtained. This is because, even when there is a temperature gradient (temperature variation) greater than a predetermined critical value in the front surface of the molding during sintering, it is possible to suppress crystal growth (solid phase growth) in a creeping direction of the front surface of the molding (hereinafter also simply referred to as the "creeping direction") along the temperature gradient within the front surface of the molding by intentionally generating the above-described temperature gradient during sintering. This allows an avoidance of appearance of a region where crystal grains with a grain size exceeding 30 µm are locally densely packed, for example. Also, this allows an avoidance of the generation of crystal grains with a grain size exceeding 30 µm, for example. Consequently, even when the sputtering surface 101 has a large diameter, the local appearance of a region where the above-described ratio R is not within the range of 0.3 or more and 5 or less in the sputtering surface 101, can be avoided. That is, the localized deterioration in the randomness of the orientation of crystals constituting the sputtering surface 101 can be avoided.

Moreover, since an effect of suppressing crystal growth in the creeping direction is obtained by intentionally generating the above-described temperature gradient during sintering, the target material 100 in which crystals with a grain size exceeding 30 µm are not observed in an entire area of the sputtering surface 101 and in an entire area of the surfaces parallel to the sputtering surface 101, can also be obtained. That is, the target material 100 in which the entire area of the sputtering surface 101 and the entire area of the surfaces parallel to the sputtering surface 101, comprise crystals with a grain size of 0.1 µm or more and 30 µm or less, preferably 0.1 µm or more and 20 µm or less, and more preferably 0.1 µm or more and 10 µm or less, can also be obtained,.

When the above-described temperature gradient is less than 10 °C/mm, it is difficult to obtain the above-described effect of suppressing the crystal growth in the creeping direction during sintering.

The above-described temperature gradient can be, for example, 15 °C/mm or less, whereby the target material 100 in which there is no significant difference in an orientation of crystals between the front surface and the rear surface, i.e., an orientation of crystals is almost the same between the front surface and the rear surface, can be obtained. Consequently, various physical properties such as crystal quality and other properties of the KNN-film 3 can be made uniform among a plurality of piezoelectric stacks 10 produced using the single target material 100. That is, it is possible to prevent various physical properties and other properties of the KNN-film 3 from varying from run to run in the production of piezoelectric stacks 10. Consequently, the yield and reliability of the piezoelectric element 20 and the piezoelectric device module 30 can be further improved.

Also, the effect of suppressing crystal growth in the creeping direction can be surely obtained by heating the molding (the mixture 210) while controlling temperatures of the heaters 207d and 207e based on temperatures detected by the temperature sensors 209 during sintering in such a manner that the temperature within the front surface of the molding becomes uniform (in-plane uniform), i.e., a temperature gradient within the front surface of the molding does not generate as much as possible. Consequently, the large diameter target material 100 having the ratio R within the range of 0.3 or more and 5 or less over an entire area of the sputtering surface, can be surely obtained.

Sintering (firing) can be sufficiently performed while suppressing the crystal growth in the creeping direction, by setting the sintering temperature to 800 °C or higher and 1150 °C or lower over the entire front surface of the molding and/or setting the sintering time to 1 hour or more and 5 hours or less. Consequently, the target material 100 which has the ratio R within the range of 0.3 or more and 5 or less over the entire area of the sputtering surface and has a sufficient mechanical strength, can be obtained.

When the sintering temperature is less than 800 °C (including a case where the sintering temperature is not 800 °C or higher over the entire front surface of the molding) or the sintering time is less than 1 hour, sintering is insufficient, and consequently, the obtained sintered ceramics may have low mechanical strength in some cases. Accordingly, cracks are likely to be generated in the target material 100 in the production of the target material 100 and the deposition of the KNN-film 3.

When the sintering temperature is more than 1150 °C or the sintering time is more than 5 hours, the crystal growth in the creeping direction cannot be suppressed even when the predetermined temperature gradient is generated in the thickness direction of the molding, and crystals may grow largely in some cases. Consequently, a region where crystals are not oriented randomly, may appear in the sputtering surface 101 in some cases.

The target material 100 having a relative density of 60 % or more and/or having a flexural strength of 10 MPa or more over the entire area of the sputtering surface, can also be obtained by performing the compression molding and sintering under the above-described conditions, in particular, by intentionally generating the above-described temperature gradient during sintering.

(Heating treatment)

After the compression molding treatment and the sintering treatment are finished, a predetermined heating treatment is performed on the obtained sintered ceramics using the above-described molding apparatus 200. Preferably, the heating treatment is performed while controlling temperatures of the heaters 207a to 207e based on temperatures detected by the temperature sensors 209 in such a manner that the temperature within the front surface (the surface to be the sputtering surface 101) of the sintered ceramics becomes uniform (in-plane uniform).

The following conditions are exemplified as the conditions for the heating treatment.

Temperature: 600 °C or higher and 900 °C or lower, preferably 700 °C or higher and 800 °C or lower
Atmosphere: air or atmosphere containing oxygen
Time: 1 hour or more and 20 hours or less, preferably 5 hours or more and 15 hours or less

Even in a case where carbon (C) contained in the jig 208 and O contained in the mixture 210 have reacted in the sintering treatment and oxygen vacancy has occurred in the sintered ceramics, oxygen can be replenished into oxygen vacancies in the sintered ceramics by performing the heating treatment under the above-described conditions. Consequently, the target material 100 having a higher resistivity can be obtained. For example, the target material 100 having a volume resistivity of 1000 kΩcm or more can be obtained.

(Finishing treatment)

After the heating treatment is finished, the external shape and the thickness of the molding after the heating treatment are adjusted as necessary, and surface conditions of the molding are adjusted by polishing the front surface as necessary. Thus, the target material 100 is obtained as illustrated in FIG. 5.

(6) Effects

One or more of the following effects can be obtained according to the present disclosure.

(a) A localized defective region does not appear in the entire area of the main surface of the KNN-film 3 according to the present embodiment, even though the KNN-film 3 has a large diameter (a diameter of 3 inches or more). That is, the KNN-film 3 has FWHM (001) within the range of 0.5° or more and 2.5° or less over the entire area of its main surface. Accordingly, the KNN-film 3 has uniform film quality over the entire area of the main surface, and the film properties of the KNN-film 3 are uniform over the entire area of the main surface of the KNN-film 3. Consequently, the occurrence of variation in properties can be avoided among a plurality of piezoelectric elements 20 and piezoelectric device modules 30 obtained by processing the single piezoelectric stack 10. Therefore, the yield and reliability of the piezoelectric elements 20 and the piezoelectric device modules 30 can be improved.

(b) By sputter depositing the KNN-film 3 using the target material 100 having the ratio R within the range of 0.3 or more and 5 or less over the entire area of the sputtering surface, the occurrence of abnormal discharging over the entire area of the sputtering surface during sputtering deposition, can be avoided. Consequently, the appearance of a localized defective region can be avoided over the entire area of the main surface of the KNN-film 3, even when the large diameter KNN-film 3 is deposited on the large diameter substrate 1 by sputtering. That is, by depositing the KNN-film 3 using the above-described target material 100, the large diameter KNN-film 3 having FWHM (001) within the range of 0.5° or more and 2.5° or less over the entire area of its main surface, can be obtained.

Here, as a method of evaluating the direction of crystals (orientation of crystals) constituting the sputtering surface, it is also conceivable to use a method of calculating and evaluating the ratio R at a total of 9 points, e.g., at the center of the sputtering surface, four points set at 90° intervals at a distance of half the radius from the center, and four points set at 90° intervals inward of an outer circumferential edge by a predetermined distance. However, in this evaluation method, the number of evaluation points is small when compared with the present embodiment, and therefore, the orientations of crystals over the entire area of the sputtering surface may not be evaluated accurately in some cases. Particularly in the case of a large diameter target material having the sputtering surface with a diameter of 3 inches or more, even though a region where the ratio R is not within the range of 0.3 or more and 5 or less (a region where crystals are not oriented randomly) appears locally in the sputtering surface, such a region may not be found in some cases.

In contrast, in the target material 100 according to the present embodiment, when XRD measurement is performed at measurement points set at 1 cm intervals in a grid in a region of the sputtering surface 101 excluding its periphery having a width of 5 mm from the edge, the ratio R is within the range of 0.3 or more and 5 or less at all the measurement points (e.g., 37 points in the case where the sputtering surface 101 has a diameter of 3 inches). By sputter depositing the KNN-film 3 on the large diameter substrate 1 using the target material 100, the large diameter KNN-film 3 having FWHM (001) within the range of 0.5° or more and 2.5° or less over the entire area of the main surface, can be obtained.

(c) The crystal growth in the creeping direction can be suppressed by heating the molding in the above-described sintering treatment under the condition where the temperature gradient increases from the front surface to the rear surface of the molding, at the rate of 10 °C/mm or more. Consequently, the large diameter target material 100 having the ratio R within the range of 0.3 or more and 5 or less over the entire area of the sputtering surface, can be obtained.

(d) The large diameter target material 100 which has the ratio R within the range of 0.3 or more and 5 or less over the entire area of the sputtering surface and has sufficient mechanical strength, can be obtained by heating the molding in the above-described sintering treatment for 1 hour or more and 5 hours or less under the condition where the sintering temperature is 800 °C or higher and 1150 °C or lower over the entire front surface of the molding and under the condition of the above-described temperature gradient.

(7) Modified Examples

The present embodiment can be modified to the following modified examples. In the following description of the modified examples, the same reference numerals are given to components that are the same as those in the above-described embodiment, and descriptions thereof are omitted. The above-described embodiment and the following modified examples can be suitably combined.

(Modified Example 1)

The piezoelectric stack 10 does not necessarily have to include the bottom electrode film 2. That is, the piezoelectric stack 10 may be configured to include the large diameter substrate 1, the large diameter KNN-film 3 on the substrate 1, and the top electrode film 4 (an electrode film) on the KNN-film 3.

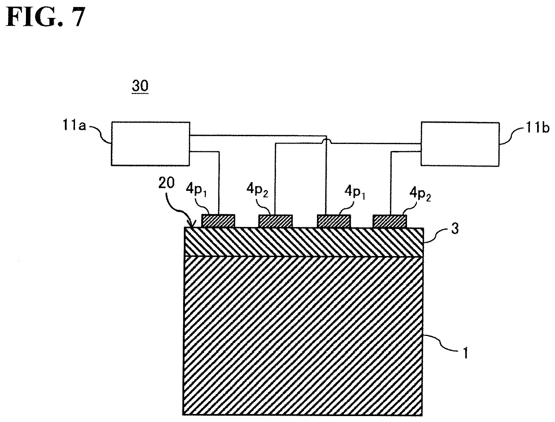

FIG. 7 illustrates a schematic configuration view of a piezoelectric device module 30 produced using the piezoelectric stack 10 according to this modified example. The piezoelectric device module 30 includes at least a piezoelectric element 20 obtained by forming the piezoelectric stack 10 into a predetermined shape, and the voltage applicator 11a and the voltage detector 11b that are connected to the piezoelectric element 20. In this modified example, the piezoelectric element 20 includes pattern electrodes obtained by forming the electrode film into a predetermined pattern. For example, the piezoelectric element 20 includes a pair of positive and negative input-side pattern electrodes $4p_1$ and a pair of positive and negative output-side pattern electrodes $4p_2$. For example, the pattern electrodes $4p_1$ and $4p_2$ are interdigital transducers (abbreviated as IDTs).

By connecting the voltage applicator 11a between the pattern electrodes $4p_1$ and connecting the voltage detector 11b between the pattern electrodes $4p_2$, the piezoelectric device module 30 can function as a filter device such as a surface acoustic wave (abbreviated as SAW) filter. By applying a voltage between the pattern electrodes $4p_1$ using the voltage applicator 11a, SAWs can excite in the KNN-film 3. A frequency of excited SAWs can be adjusted by adjusting, for example, a pitch between the pattern electrodes $4p_1$. For example, the shorter the pitch of an IDT as the pattern electrodes $4p_1$ is, the higher the frequency of SAWs is, and the longer the pitch is, the lower the frequency of SAWs is. A voltage is generated between the pattern electrodes $4p_2$, due to SAWs having a predetermined frequency (frequency component) determined according to the pitch of an IDT or the like as the pattern electrodes $4p_2$ out of SAWs which is excited by the voltage applicator 11a, propagates in the KNN-film 3, and reaches the pattern electrodes $4p_2$. By detecting the voltage using the voltage detector 11b, the SAWs having the predetermined frequency from the excited SAWs can be extracted. The term "predetermined frequency" referred to here may encompass not only the predetermined frequency but also a predetermined frequency band whose center frequency is the predetermined frequency.

In this modified example as well, by sputter depositing the KNN-film 3 using the target material 100 having the ratio R within the range of 0.3 or more and 5 or less over the entire area of the sputtering surface, the large diameter KNN-film 3 having FWHM (001) within the range of 0.5° or more and 2.5° or less over the entire area of its main surface, can be obtained.

Also, in this modified example as well, FWHM (001) is within the range of 0.5° or more and 2.5° or less over the entire area of the main surface of the large diameter KNN-film 3. Accordingly, the KNN-film 3 can have uniform film properties over the entire area of the main surface of the KNN-film 3. Therefore, in this modified example as well, the occurrence of variation in properties can be avoided among a plurality of piezoelectric elements 20 (piezoelectric device modules 30) obtained from the single piezoelectric stack 10. Consequently, the yield and reliability of the piezoelectric elements 20 (the piezoelectric device modules 30) can be improved.


(Modified Example 2)


In the above-described embodiment, explanation has been given for an example where, in the mixing treatment when producing the target material 100, powder (e.g., $K_2CO_3$-powder) comprising the K-compound, powder (e.g., $Na_2CO_3$-powder) comprising the Na-compound, and powder (e.g., $Nb_2O_5$-powder) comprising the Nb-compound are mixed at a predetermined ratio, but the present disclosure is not limited thereto. For example, in the mixing treatment, the mixture may be obtained by mixing powder comprising a compound containing K and Nb, and powder comprising a compound containing Na and Nb, at a predetermined ratio.

The compound containing K and Nb is at least one selected from a group consisting of oxides (complex oxides) containing K and Nb, and compounds (e.g., a carbonic acid salt and an oxalic acid salt) that contain K and Nb and become oxides when heated. For example, a $KNbO_3$-powder can be used as the powder comprising the compound containing K and Nb. The $KNbO_3$-powder can be obtained by, for example, mixing a K-compound (e.g., $K_2CO_3$-powder) and an Nb-compound (e.g., $Nb_2O_5$-powder), pre-sintering the mixture, and then pulverizing and mixing the mixture after pre-sintering, using a ball mill or the like.

The compound containing Na and Nb is at least one selected from a group consisting of oxides (complex oxides) containing Na and Nb, and compounds (e.g., a carbonic acid salt and an oxalic acid salt) that contain Na and Nb and become oxides when heated. For example, a $NaNbO_3$-powder can be used as the powder comprising the compound containing Na and Nb. The $NaNbO_3$-powder can be obtained by, for example, mixing an Na-compound (e.g., $Na_2CO_3$-powder) and the Nb-compound (e.g., $Nb_2O_5$-powder), pre-sintering the mixture, and then pulverizing and mixing the mixture after pre-sintering, using a ball mill or the like.

In this case, the composition of the target material 100 can be controlled by adjusting a mixing ratio of the $KNbO_3$-powder and the $NaNbO_3$-powder, a mixing ratio of the K-compound and the Nb-compound in the production of the $KNbO_3$-powder, and a mixing ratio of the Na-compound and the Nb-compound in the production of the $NaNbO_3$-powder.

In this modified example, pre-sintering conditions in the production of the $KNbO_3$-powder and the production of the $NaNbO_3$-powder can be similar to the conditions of the pre-sintering treatment in the above-described embodiment, and mixing conditions in the production of them can be similar to the conditions of the mixing treatment in the above-described embodiment.

In this modified example as well, the large diameter target material 100 having the ratio R within the range of 0.3 or more and 5 or less over the entire area of the sputtering surface, can be obtained by heating the molding in the sintering treatment for 1 hour or more and 5 hours or less under the condition where the temperature within the front surface of the molding is 800 °C or higher and 1150 °C or lower over the entire front surface, and the condition where the temperature gradient increases from the front surface to the rear surface of the molding, at the rate of 10 °C/mm or more. Also, the large diameter KNN-film 3 having FWHM (001) within the range of 0.5° or more and 2.5° or less over the entire area of the main surface by sputter depositing the KNN-film 3 using the target material 100, can be obtained.

(Modified Example 3)

In the above-described embodiment and modified examples, explanation has been given for an example where the mixing method of each powder is a wet mixing method in the mixing treatment and the pulverization treatment, but the present disclosure is not limited thereto. The mixing method in the mixing treatment may be a dry mixing method. That is, in the mixing treatment, powders may be mixed using a mixer such as an attritor.

(Modified Example 4)

In the above-described embodiment, explanation has been given for an example where the compression molding treatment and the sintering treatment are performed at the same time, i.e., hot press sintering is performed, but the present disclosure is not limited thereto. For example, the sintering treatment may be performed after the compression molding treatment. That is, the sintered ceramics may be obtained as follows: using the molding apparatus 200 illustrated in, for example, FIG. 6, the mixture 210 within the jig 208 is compression-molded by applying a predetermined pressure, to obtain the molding, and thereafter the molding is heated and sintered under predetermined conditions.

The following conditions are exemplified as the conditions for the compression molding treatment in this modified example.

Temperature: room temperature (25 °C) or higher, preferably 25 °C or higher and 50 °C or lower Other conditions can be similar to the conditions of the compression molding treatment in the above-described embodiment.

In this modified example as well, the molding is heated in the sintering treatment for 1 hour or more and 5 hours or less under the condition where the temperature within the front surface is 800 °C or higher and 1150 °C or lower over the entire its surface, and the condition where the temperature gradient increases from the front surface to the rear surface of the molding, at the rate of 10 °C/mm or more. Other conditions of the sintering treatment in this modified example can be similar to the conditions of the sintering treatment in the above-described embodiment.

According to this modified example as well, the large diameter target material 100 having the ratio R within the range of 0.3 or more and 5 or less over the entire area of the sputtering surface, can be obtained by performing the sintering treatment under the above-described conditions. Also, the large diameter KNN-film 3 having FWHM (001) within the range of 0.5° or more and 2.5° or less over the entire area of the main surface, can be obtained by sputter depositing the KNN-film 3 using the target material 100.

(Modified Example 5)

In the above-described embodiment and modified examples, explanation has been given for an example where the series of treatments from the compression molding treatment to the heating treatment are performed in the single molding apparatus 200, but the present disclosure is not limited thereto. It is acceptable to perform the compression molding treatment, the sintering treatment, and the heating treatment using different apparatuses, or perform two treatments of these treatments using the same apparatus and perform the other treatment using a different apparatus.

(Modified Example 6)

In the above-described embodiment, explanation has been given for an example where the pre-sintering treatment, the pulverization treatment, and the heating treatment are performed, but the present disclosure is not limited thereto. These treatments may be performed as necessary. That is, these treatments may be omitted as long as the large diameter target material 100 having the ratio R within the range of 0.3 or more and 5 or less over the entire area of the sputtering surface, can be obtained.

(Modified Example 7)

In the above-described embodiment, explanation has been given for an example where the heater 207 includes the upper heater 207a, the middle heater 207b, the lower heater 207c, the inside heater 207d, and the outside heater 207e, but the present disclosure is not limited thereto. There is no particular limitation on the configuration of the heater 207 as long as the sintering treatment can be performed under the condition where the temperature within the front surface of the molding is 800 °C or higher and 1150 °C or lower over the entire surface, and under the condition where the temperature gradient increases from the front surface to the rear surface of the molding, at the rate of 10 °C/mm or more.

(Modified Example 8)

For example, heating in each of the pre-sintering treatment, the sintering treatment, and the heating treatment, may be performed by divided a plurality of times. According to this modified example as well, the large diameter target material 100 having the ratio R within the range of 0.3 or more and 5 or less over the entire area of the sputtering surface, can be obtained.

(Modified Example 9)

For example, the jig 208 may be connected to a rotation mechanism via a rotation shaft and configured to be rotatable. The heating treatment in the above-described embodiment and modified examples, the sintering treatment in the modified example 4, and the like may be performed while rotating the jig 208 via the rotation shaft using the rotation mechanism. Consequently, it is easy to heat the molding and the sintered ceramics uniformly over their surfaces, and it is easy to make various physical properties and the like of the target material 100 uniform over the entire area of the sputtering surface.

(Modified Example 10)

For example, an orientation control layer which controls the orientation of crystals constituting the KNN-film 3 may be provided between the bottom electrode film 2 and the KNN-film 3, i.e., directly under the KNN-film 3. When the bottom electrode film 2 is not provided, the orientation control layer may be provided between the substrate 1 and the KNN-film 3. The orientation control layer can be formed using a material which is a metal oxide such as SRO, LNO, or strontium titanium oxide ($SrTiO_3$, abbreviated as STO), and which is different from the material of the bottom electrode film 2, for example. Crystals constituting the orientation control layer are preferably preferentially oriented in (100) to the main surface of the substrate 1. Consequently, the orientation percentage of the KNN-film 3 can be surely 80 % or more, and preferably 90 % or more.

(Modified Example 11)

In the above-described embodiment, explanation has been given for an example where one stack structure is formed on one substrate 1, but the present disclosure is not limited thereto. For example, a plurality of stack structures may be formed on one substrate 1. In this case, each of the plurality of stack structures preferably includes the bottom electrode film 2, the KNN film 3, and the top electrode film 4. In the case of an embodiment according to the modified example 1, each of the plurality of stack structures preferably includes the KNN-film 3 and the electrode film 4. The substrate 1 on which one or more stack structures are formed is also referred to as a piezoelectric stacked substrate.

(Modified Example 12)

For example, when forming the above-described piezoelectric stack 10 into the piezoelectric element 20, the substrate 1 may be removed from the piezoelectric stack 10 as long as the piezoelectric device module 30 produced using the piezoelectric stack 10 (the piezoelectric element 20) can be used for a desired application such as a sensor or actuator.

Examples

Hereinafter, explanation will be given for experimental results supporting the effects of the above-described embodiment.

(Samples 1 and 2)

Target materials having a diameter of 3 inches and comprising a sintered ceramics of $(K_{1-x}Na_x)NbO_3$ containing Mn at a predetermined concentration were produced as samples 1 and 2 using the molding apparatus 200 illustrated in FIG. 6.
Each of the samples 1 and 2 was produced by performing the mixing treatment, the pre-sintering treatment, the pulverization treatment, the compression molding treatment, the sintering treatment, and the heating treatment. The compression molding treatment and the sintering treatment were performed at the same time (together). In the mixing treatment, a mixture was prepared by mixing a $K_2CO_3$-powder, a $Na_2CO_3$-powder, and a $Nb_2O_5$-powder in such a manner that the value Na/(K+Na) was 0.55, and by adding a MnO-powder in such a manner that Mn was contained at the predetermined concentration. In the compression molding treatment, a molding was produced by applying a load of 300 $kgf/cm^2$. In the sintering treatment, the molding was heated for 3 hours under a condition where a temperature (a sintering temperature) within a front surface of the molding was 900 °C over an entire its surface, and a condition where a temperature gradient increased from the front surface to a rear surface of the molding, at a rate of 10 °C/mm. Other conditions in each treatment were set to be prescribed conditions within the ranges of conditions for the respective treatments described in the above embodiment.

(Samples 3 to 8)

In samples 3 to 8, the temperature gradient increasing from the front surface to the rear surface of the molding in the sintering treatment was changed from that in sample 1. Specifically, the above-described temperature gradient was set to 12 °C/mm in samples 3 and 4, 15 °C/mm in samples 5 and 6, 5 °C/mm in sample 7, and 7 °C/mm in sample 8. Other conditions were similar to those in the production of sample 1.

(Samples 9 to 13)

In samples 9 to 13, the sintering temperature in the sintering treatment was changed from that in sample 1. Specifically, in sample 9, the sintering temperature was set to 750 °C over the entire front surface of the molding. In sample 10, the sintering temperature was set to 800 °C over the entire front surface of the molding. In sample 11, the sintering temperature was set to 1000 °C over the entire front surface of the molding. In sample 12, the sintering temperature was set to 1150 °C over the entire front surface of the molding. In sample 13, the sintering temperature was set to 1200 °C over the entire front surface of the molding. Other conditions were similar to those in the production of sample 1.

(Samples 14 to 17)

In samples 14 to 17, the load in the compression molding treatment was changed from that in sample 1. Specifically, the load was set to 100 $kgf/cm^2$ in sample 14, 200 $kgf/cm^2$ in sample 15, 400 $kgf/cm^2$ in sample 16, and 500 $kgf/cm^2$ in sample 17. Other conditions were similar to those in the production of sample 1.

(Samples 18 to 23)

In samples 18 to 23, the time (sintering time) for heating the molding in the sintering treatment was changed from that in sample 1. Specifically, the sintering time was set to 0.5 hours in sample 18, 1 hour in sample 19, 2 hours in sample 20, 4 hours in sample 21, 5 hours in sample 22, and 5.5 hours in sample 23. Other conditions were similar to those in the production of sample 1.

(Sample 24)

In sample 24, a target material having a diameter of 3 inches and comprising a sintered ceramics of $(K_{1-x}Na_x)NbO_3$ not containing a dopant such as Mn was produced. Specifically, a mixture was prepared in the mixing treatment by mixing the $K_2CO_3$-powder, the $Na_2CO_3$-powder, and the $Nb_2O_5$-powder in such a manner that the value Na/(K+Na) was 0.55, without adding the MnO-powder. Other conditions were similar to those in the production of sample 1.

(Sample 25)

In sample 25, the sintering treatment was performed after the compression molding treatment. That is, the compression molding treatment and the sintering treatment were performed separately from each other. Other conditions were similar to those in the production of sample 1.

(Sample 26)

In sample 26, the compression molding treatment and the sintering treatment were performed separately from each other. Other conditions were similar to those in the production of sample 24.

(Samples 27 and 28)

In samples 27 and 28, the composition of the sintered ceramics of $(K_{1-x}Na_x)NbO_3$, i.e., the composition of the target material was changed from that in sample 1. Specifically, in sample 27, a mixture was prepared in the mixing treatment by mixing the $K_2CO_3$-powder, the $Na_2CO_3$-powder, and the $Nb_2O_5$-powder in such a manner that the value Na/(K+Na) was 0.40. In sample 28, a mixture was prepared by mixing the $K_2CO_3$-powder, the $Na_2CO_3$-powder, and the $Nb_2O_5$-powder in such a manner that the value Na/(K+Na) was 0.70. Other conditions were similar to those in the production of sample 1.

(Samples 29 to 32)

In samples 29 to 32, target materials having a diameter of 4 inches and comprising a sintered ceramics of $(K_{1-x}Na_x)NbO_3$ containing Cu at a predetermined concentration as a dopant were produced. Specifically, in samples 29 to 32, a mixture was prepared in the mixing treatment by mixing a CuO-powder at a predetermined ratio instead of the MnO-powder. Also, the above-described temperature gradient in the sintering treatment was set to 12 °C/mm in sample 30, 3 °C/mm in sample 31, and 8 °C/mm in sample 32. Other conditions were similar to those in the production of sample 1.

(Samples 33 to 36)

In samples 33 to 36, target materials having a diameter of 6 inches and comprising a sintered ceramics of $(K_{1-x}Na_x)NbO_3$ containing Cu at a predetermined concentration and Mn at a predetermined concentration were produced. Specifically, in samples 33 to 36, a mixture was prepared in the mixing treatment by mixing the CuO-powder and the MnO-powder, at predetermined ratios. Also, the above-described temperature gradient in the sintering treatment was set to 14 °C/mm in sample 34, 4 °C/mm in sample 35, and 9 °C/mm in sample 36. Other conditions were similar to those in the production of sample 1.

The following Table 1 shows a list of the production conditions and target sizes of the above-described target materials of samples 1 to 36.

[Table 1]

| Sample No. | Dopant | Composition | Compression molding treatment | Sintering treatment | | | Compression molding treatment and sintering treatment | Target size |
| --- | --- | --- | --- | --- | --- | --- | --- | --- |
| | | (Ratio: Na/(K+Na)) | Load (kgf/cm²) | Sintering temperature (°C) | Sintering time (hours) | Temperature gradient (°C/mm) | | |
| 1 | Mn | 0.55 | 300 | 900 | 3 | 10 | Together | 3 in. |
| 2 | Mn | 0.55 | 300 | 900 | 3 | 10 | Together | 3 in. |
| 3 | Mn | 0.55 | 300 | 900 | 3 | 12 | Together | 3 in. |
| 4 | Mn | 0.55 | 300 | 900 | 3 | 12 | Together | 3 in. |
| 5 | Mn | 0.55 | 300 | 900 | 3 | 15 | Together | 3 in. |
| 6 | Mn | 0.55 | 300 | 900 | 3 | 15 | Together | 3 in. |
| 7 | Mn | 0.55 | 300 | 900 | 3 | 5 | Together | 3 in. |
| 8 | Mn | 0.55 | 300 | 900 | 3 | 7 | Together | 3 in. |
| 9 | Mn | 0.55 | 300 | 750 | 3 | 10 | Together | 3 in. |
| 10 | Mn | 0.55 | 300 | 800 | 3 | 10 | Together | 3 in. |
| 11 | Mn | 0.55 | 300 | 1000 | 3 | 10 | Together | 3 in. |
| 12 | Mn | 0.55 | 300 | 1150 | 3 | 10 | Together | 3 in. |
| 13 | Mn | 0.55 | 300 | 1200 | 3 | 10 | Together | 3 in. |
| 14 | Mn | 0.55 | 100 | 900 | 3 | 10 | Together | 3 in. |

(continued)

| Sample No. | Production conditions of target material | | | | | | | Target size |
|---|---|---|---|---|---|---|---|---|
| | Dopant | Composition | Compression molding treatment | Sintering treatment | | | Compression molding treatment and sintering treatment | |
| | | (Ratio: Na/(K+Na)) | Load (kgf/cm$^2$) | Sintering temperature (°C) | Sintering time (hours) | Temperature gradient (°C/mm) | | |
| 15 | Mn | 0.55 | 200 | 900 | 3 | 10 | Together | 3 in. |
| 16 | Mn | 0.55 | 400 | 900 | 3 | 10 | Together | 3 in. |
| 17 | Mn | 0.55 | 500 | 900 | 3 | 10 | Together | 3 in. |
| 18 | Mn | 0.55 | 300 | 900 | 0.5 | 10 | Together | 3 in. |
| 19 | Mn | 0.55 | 300 | 900 | 1 | 10 | Together | 3 in. |
| 20 | Mn | 0.55 | 300 | 900 | 2 | 10 | Together | 3 in. |
| 21 | Mn | 0.55 | 300 | 900 | 4 | 10 | Together | 3 in. |
| 22 | Mn | 0.55 | 300 | 900 | 5 | 10 | Together | 3 in. |
| 23 | Mn | 0.55 | 300 | 900 | 5.5 | 10 | Together | 3 in. |
| 24 | None | 0.55 | 300 | 900 | 3 | 10 | Together | 3 in. |
| 25 | Mn | 0.55 | 300 | 900 | 3 | 10 | Separately | 3 in. |
| 26 | None | 0.55 | 300 | 900 | 3 | 10 | Separately | 3 in. |
| 27 | Mn | 0.40 | 300 | 900 | 3 | 10 | Together | 3 in. |
| 28 | Mn | 0.70 | 300 | 900 | 3 | 10 | Together | 3 in. |
| 29 | Cu | 0.55 | 300 | 900 | 3 | 10 | Together | 4 in. |
| 30 | Cu | 0.55 | 300 | 900 | 3 | 12 | Together | 4 in. |
| 31 | Cu | 0.55 | 300 | 900 | 3 | 3 | Together | 4 in. |
| 32 | Cu | 0.55 | 300 | 900 | 3 | 8 | Together | 4 in. |
| 33 | Cu&Mn | 0.55 | 300 | 900 | 3 | 10 | Together | 6 in. |
| 34 | Cu&Mn | 0.55 | 300 | 900 | 3 | 14 | Together | 6 in. |
| 35 | Cu&Mn | 0.55 | 300 | 900 | 3 | 4 | Together | 6 in. |
| 36 | Cu&Mn | 0.55 | 300 | 900 | 3 | 9 | Together | 6 in. |

<Evaluation>

With regard to the target materials of samples 1 to 36, evaluations of cracks and the ratio R were performed, and evaluations of KNN-films deposited by sputtering using the respective samples were performed.

(Evaluation of cracks)

Each sample was evaluated the presence or absence of cracks by visual observation. As a result, it was confirmed that there were cracks in samples 9 and 18, and there were no cracks in samples other than samples 9 and 18. From this result, it can be confirmed that when the sintering temperature is lower than 800 °C or the sintering time is less than 1 hour, sintering cannot be performed sufficiently, and the obtained sintered ceramics has low mechanical strength.

(Evaluation of ratio R)

With regard to each sample other than samples 9 and 18 in which cracks were generated, XRD measurement was performed on the sputtering surface of the target material, and the ratio R of the (110) peak intensity with respect to the (001) peak intensity was calculated. XRD measurement was performed at measurement points set at 1 cm intervals in a grid in a region of the sputtering surface excluding region having a width of 5 mm from the edge of the sputtering surface. That is, XRD measurement was performed at 37 points in samples (samples 1 to 28) with a diameter of 3 inches, 69 points in samples (samples 29 to 32) with a diameter of 4 inches, and 147 points in samples (samples 33 to 36) with a diameter of 6 inches. The ratio R was calculated for all the measurement points of the XRD measurement. Calculation results are shown in the following Table 2. Note that in "Evaluation of ratio R" shown in Table 2, "Number of acceptable measurement points" means the number of measurement points at which the ratio R was within the range of 0.3 or more and 5 or less, and "Acceptance ratio" means the ratio of the number of the acceptable measurement points to the number of all measurement points (= the number of acceptable measurement points / the number of all measurement points).

(Evaluation of KNN-film)

KNN-films were deposited by the following procedure using samples other than samples 9 and 18 in which cracks were generated.

In the sputtering deposition performed using samples 1, 3, 5, 7, 8, 10 to 17, and 19 to 28, first, a Si-substrate with a diameter of 4 inches, a thickness of 510 $\mu$m, a surface oriented in (100) direction, and a thermal oxide film (SiO$_2$-film) having a thickness of 200 nm on its surface, was prepared. Then, a Ti-layer (thickness: 2 nm) as an adhesion layer, a Pt-film (oriented in (111) direction to a main surface of the substrate and having a thickness of 200 nm) as a bottom electrode film, and a KNN-film (preferentially oriented in (001) direction to the surface of the substrate and having a thickness of 2 $\mu$m) with a diameter of 4 inches, were deposited in this order on the substrate (thermal oxide film) by a RF magnetron sputtering method.

In the sputtering deposition performed using samples 2, 4, 6, and 29 to 36, first, a Si-substrate with a diameter of 6 inches, a thickness of 610 $\mu$m, a surface oriented in (100) direction, and a thermal oxide film (SiO$_2$-film) having a thickness of 200 nm on its surface, was prepared. Then, a Ti-layer (thickness: 2 nm) as an adhesion layer, a Pt-film (oriented in (111) direction to a main surface of the substrate and having a thickness of 200 nm) as a bottom electrode film, and a KNN-film (preferentially oriented in (001) direction to the surface of the substrate and having a thickness of 2 $\mu$m) with a diameter of 6 inches, were deposited in this order on the substrate (thermal oxide film) by the RF magnetron sputtering method.

Conditions for depositing the Ti-layer were as follows.

Temperature (substrate temperature): 300 °C
RF-power: 1200 W
Atmosphere: Ar-gas atmosphere
Atmosphere pressure: 0.3 Pa
Deposition rate: rate at which a Ti-layer with a thickness of 2.5 nm is deposited in 30 seconds

Conditions for depositing the Pt-film were as follows.

Temperature (substrate temperature): 300 °C
RF-power: 1200 W
Atmosphere: Ar-gas atmosphere
Atmosphere pressure: 0.3 Pa
Time: 5 minutes

Each sample other than the above-described samples 9 and 18 was used as a target material when depositing the KNN-film. Conditions for depositing the KNN-film were as follows.

RF-power: 2200 W
Atmosphere: mixed gas atmosphere comprising Ar-gas and O$_2$-gas
Atmosphere pressure: 0.3 Pa
Ar/O$_2$-partial pressure ratio: 25/1
Temperature (substrate temperature): 600 °C
Deposition rate: 1 $\mu$m/hr

XRD measurement was performed on the KNN-film deposited by sputtering, to obtain FWHM (001). The XRD measurement was performed at measurement points set at 1 cm intervals in a grid in a region of a main surface (top surface) of the KNN-film excluding region having a width of 5 mm from the edge of the main surface. That is, the XRD measurement was performed at 69 points in KNN-films with a diameter of 4 inches, and 147 points in KNN-films with a diameter of 6 inches. Measurement results are shown in the following Table 2. Note that in "Evaluation of KNN-film" shown in Table 2, "Number of acceptable measurement points" means the number of measurement points at which FWHM (001) was within the range of 0.5° or more and 2.5° or less, and "Acceptance ratio" means the ratio of the number of acceptable measurement points to the number of all measurement points (= the number of acceptable measurement points/the number of all measurement points).

[Table 2]

| Sample No. | Evaluation | | | | | | | |
|---|---|---|---|---|---|---|---|---|
| | Evaluation of cracks | Evaluation of ratio R | | | Evaluation of KNN-film | | | |
| | | Number of XRD measurement points | Number of acceptable measurement points | Acceptance ratio | Size | XRD measurement points | Acceptable measurement points | Acceptance ratio |
| 1 | Absent | 37 | 37 | 1 | 4 in. | 69 | 69 | 1 |
| 2 | Absent | 37 | 37 | 1 | 6 in. | 69 | 69 | 1 |
| 3 | Absent | 37 | 37 | 1 | 4 in. | 69 | 69 | 1 |
| 4 | Absent | 37 | 37 | 1 | 6 in. | 69 | 69 | 1 |
| 5 | Absent | 37 | 37 | 1 | 4 in. | 69 | 69 | 1 |
| 6 | Absent | 37 | 37 | 1 | 6 in. | 69 | 69 | 1 |
| 7 | Absent | 37 | 31 | 0.84 | 4 in. | 69 | 60 | 0.87 |
| 8 | Absent | 37 | 35 | 0.95 | 4 in. | 69 | 63 | 0.91 |
| 9 | Present | - | - | - | - | - | - | - |
| 10 | Absent | 37 | 37 | 1 | 4 in. | 69 | 69 | 1 |
| 11 | Absent | 37 | 37 | 1 | 4 in. | 69 | 69 | 1 |
| 12 | Absent | 37 | 37 | 1 | 4 in. | 69 | 69 | 1 |
| 13 | Absent | 37 | 33 | 0.89 | 4 in. | 69 | 54 | 0.78 |
| 14 | Absent | 37 | 37 | 1 | 4 in. | 69 | 69 | 1 |
| 15 | Absent | 37 | 37 | 1 | 4 in. | 69 | 69 | 1 |
| 16 | Absent | 37 | 37 | 1 | 4 in. | 69 | 69 | 1 |
| 17 | Absent | 37 | 37 | 1 | 4 in. | 69 | 69 | 1 |
| 18 | Present | - | - | - | - | - | - | - |
| 19 | Absent | 37 | 37 | 1 | 4 in. | 69 | 69 | 1 |
| 20 | Absent | 37 | 37 | 1 | 4 in. | 69 | 69 | 1 |
| 21 | Absent | 37 | 37 | 1 | 4 in. | 69 | 69 | 1 |
| 22 | Absent | 37 | 37 | 1 | 4 in. | 69 | 69 | 1 |
| 23 | Absent | 37 | 32 | 0.86 | 4 in. | 69 | 55 | 0.80 |

| Sample No. | Evaluation | | | | | | | |
|---|---|---|---|---|---|---|---|---|
| | Evaluation of cracks | Evaluation of ratio R | | | Evaluation of KNN-film | | | |
| | | Number of XRD measurement points | Number of acceptable measurement points | Acceptance ratio | Size | XRD measurement points | Acceptable measurement points | Acceptance ratio |
| 24 | Absent | 37 | 37 | 1 | 4 in. | 69 | 69 | 1 |
| 25 | Absent | 37 | 37 | 1 | 4 in. | 69 | 69 | 1 |
| 26 | Absent | 37 | 37 | 1 | 4 in. | 69 | 69 | 1 |
| 27 | Absent | 37 | 37 | 1 | 4 in. | 69 | 69 | 1 |
| 28 | Absent | 37 | 37 | 1 | 4 in. | 69 | 69 | 1 |
| 29 | Absent | 69 | 69 | 1 | 6 in. | 147 | 147 | 1 |
| 30 | Absent | 69 | 69 | 1 | 6 in. | 147 | 147 | 1 |
| 31 | Absent | 69 | 60 | 0.87 | 6 in. | 147 | 110 | 0.75 |
| 32 | Absent | 69 | 65 | 0.94 | 6 in. | 147 | 115 | 0.78 |
| 33 | Absent | 147 | 147 | 1 | 6 in. | 147 | 147 | 1 |
| 34 | Absent | 147 | 147 | 1 | 6 in. | 147 | 147 | 1 |
| 35 | Absent | 147 | 130 | 0.88 | 6 in. | 147 | 120 | 0.82 |
| 36 | Absent | 147 | 138 | 0.94 | 6 in. | 147 | 132 | 0.90 |

It can be confirmed from Table 2 that in both the case where the target material contains at least one of Mn and Cu as a dopant and the case where the target material does not contain a dopant, a target material having the ratio R within the range of 0.3 or more and 5 or less over the entire area of the sputtering surface, can be obtained by performing the sintering treatment (hereinafter also referred to as a "sintering treatment under predetermined conditions") in which the molding is heated for 1 hour or more and 5 hours or less under the condition where the temperature within the front surface of the molding is 800 °C or higher and 1150 °C or lower over the entire front surface, and under the condition where the temperature gradient increases from the front surface to the rear surface of the molding, at the rate of 10 °C/mm or more (see samples 1 to 6, 10 to 12, 19 to 22, 24, 29, 30, 33, and 34). That is, it can be confirmed that a target material in which crystals are oriented randomly over the entire area of the sputtering surface, can be obtained by performing the sintering treatment under the above-described conditions.

The inventors also confirmed that, when the above-described temperature gradient in the sintering treatment is 15 °C/mm or less, an orientation of crystals can be almost the same between the sputtering surface of the target material and the surface of the target material opposite to the sputtering surface while also making the ratio R fall within the range of 0.3 or more and 5 or less, over the entire area of the sputtering surface.

Also, it can be confirmed from Table 2 that, when the above-described temperature gradient in the sintering treatment is less than 10 °C/mm, the acceptance ratio of the ratio R may be less than 1 in some cases, i.e., a target material having the ratio R within the range of 0.3 or more and 5 or less over the entire area of the sputtering surface, may not be obtained in some cases (see samples 7, 8, 31, 32, 35, and 36). This is presumably because it becomes difficult to obtain the effect of suppressing crystal growth in the creeping direction of the front surface of the molding during sintering.

Also, it can be confirmed from Table 2 that, when the sintering temperature is more than 1150 °C or the sintering time is more than 5 hours, the acceptance ratio of the ratio R over the entire area of the sputtering surface may be less than 1 in some cases, i.e., a target material having the ratio R within the range of 0.3 or more and 5 or less over the entire area of the sputtering surface, may not be obtained in some cases (see samples 13 and 23). It is considered that, in the case where the sintering temperature was more than 1150 °C or the case where the sintering time was more than 5 hours, crystal growth in the creeping direction could not be suppressed even when the sintering treatment was performed under the condition satisfying the above-described temperature gradient, and therefore, a region where crystals were not oriented randomly, appeared locally in the sputtering surface.

Also, it can be confirmed from Table 2 that, when the load applied in the compression molding treatment is within the range of 100 kgf/cm² or more and 500 kgf/cm² or less, it is possible to obtain a target material in which crystals are oriented randomly over the entire area of the sputtering surface while also avoiding the generation of cracks (see samples 14 to 17). The inventors also confirmed that the jig that is used in the compression molding did not break when the load applied in the compression molding treatment was within the above-described range.

Also, it can be confirmed from Table 2 that, even when the sintering treatment is performed after the compression molding treatment, a target material in which crystals are oriented randomly over the entire area of the sputtering surface, can be obtained by performing the predetermined sintering treatment (see samples 25 and 26).

Also, it can be confirmed from Table 2 that, a target material in which crystals are oriented randomly over the entire area of the sputtering surface, can be obtained by performing the predetermined sintering treatment, irrespective of the composition of KNN in the target material (see samples 27 and 28).

Also, it can be confirmed from Table 2 that, a large diameter KNN-film having FWHM (001) within the range of 0.5° or more and 2.5° or less over the entire area of the main surface, can be obtained by sputter depositing the KNN-film on the large diameter substrate using a target material having the ratio R within the range of 0.3 or more and 5 or less over the entire area of the sputtering surface. Moreover, it can be confirmed from Table 2 that, when a KNN-film is deposited on the large diameter substrate by sputtering using the target material having the ratio R within the range of 0.3 or more and 5 or less over the entire area of the sputtering surface, the acceptance ratio is less than 1, i.e., the large diameter KNN-film having FWHM (001) within the range of 0.5° or more and 2.5° or less over the entire area of the main surface, is not obtained. That is, it can be confirmed that a localized defective region appeared in the main surface of the KNN-film.

<Preferable Aspects of Present Disclosure>

Preferable aspects of the present disclosure will be supplementarily described hereinafter.

(Supplementary description 1)

According to an aspect of the present disclosure, there is provided a piezoelectric stack including:

a substrate having a main surface with a diameter of 3 inches or more; and
a piezoelectric film on the substrate, comprising a perovskite-type alkali niobium oxide containing potassium, sodium, niobium, and oxygen,

wherein a half-value width of an X-ray rocking curve of (001) is within a range of 0.5° or more and 2.5° or less over an entire area of an inside of a main surface of the piezoelectric film excluding its periphery when performing X-ray diffraction measurement on the piezoelectric film.

(Supplementary description 2)

Preferably, there is provided the stack according to the supplementary description 1, wherein the piezoelectric film contains at least one element selected from a group consisting of Li, Mg, Ca, Sr, Ba, Bi, Sb, V, In, Ta, Mo, W, Cr, Ti, Zr, Hf, Sc, Y, La, Ce, Pr, Nd, Sm, Eu, Gd, Tb, Dy, Ho, Er, Tm, Yb, Lu, Cu, Zn, Ag, Mn, Fe, Co, Ni, Al, Si, Ge, Sn, and Ga, as a dopant.

(Supplementary description 3)

Preferably, there is provided the stack according to the supplementary description 1 or 2, the stack including a bottom electrode film between the substrate and the piezoelectric film.

(Supplementary description 4)

Preferably, there is provided the stack according to any one of the supplementary descriptions 1 to 3, the stack further including a top electrode film on the piezoelectric film.

(Supplementary description 5)

According to another aspect of the present disclosure, there is provided a method of manufacturing a piezoelectric stack, including:

preparing a sputtering target material comprising a sintered ceramics of a perovskite-type alkali niobium oxide containing potassium, sodium, niobium, and oxygen;
preparing a substrate having a main surface with a diameter of 3 inches or more; and
depositing a piezoelectric film on the substrate using the sputtering target material, the piezoelectric film comprising the alkali niobium oxide, and having a half-value width of an X-ray rocking curve of (001) within a range of 0.5° or more and 2.5° or less over an entire area of an inside of a main surface of the piezoelectric film excluding its periphery when performing X-ray diffraction measurement.

(Supplementary description 6)

According to further another aspect of the present disclosure, there is provided a piezoelectric element (a piezoelectric device module) including:

a substrate having a main surface with a diameter of 3 inches or more;
a bottom electrode film on the substrate;
a piezoelectric film on the bottom electrode film, comprising a perovskite-type alkali niobium oxide containing potassium, sodium, niobium, and oxygen; and
a top electrode film on the piezoelectric film,
wherein a half-value width of an X-ray rocking curve of (001) is within a range of 0.5° or more and 2.5° or less over an entire area of an inside of a main surface of the piezoelectric film excluding its periphery when performing X-ray diffraction measurement on the piezoelectric film.

(Supplementary description 7)

According to further another aspect of the present disclosure, there is provided a piezoelectric element (a piezoelectric device module) including:

a substrate having a main surface with a diameter of 3 inches or more;
a piezoelectric film on the substrate, comprising a perovskite-type alkali niobium oxide containing potassium, sodium, niobium, and oxygen; and
an electrode film on the piezoelectric film,
wherein a half-value width of an X-ray rocking curve of (001) is within a range of 0.5° or more and 2.5° or less over an entire area of an inside of a main surface of the piezoelectric film excluding its periphery when performing X-ray diffraction measurement on the piezoelectric film.

(Supplementary description 8)

According to further another aspect of the present disclosure, there is provided a sputtering target material comprising a sintered ceramics of a perovskite-type alkali niobium oxide containing potassium, sodium, niobium, and oxygen,

having 3 inches or more diameter of a surface (a sputtering surface) to be exposed to plasma when performing a deposition treatment using a sputtering method, and
having a ratio of an X-ray diffraction peak intensity from (110) with respect to an X-ray diffraction peak intensity from (001) within a range of 0.3 or more and 5 or less over an entire area of an inside of the surface to be exposed to plasma excluding its periphery when performing X-ray diffraction measurement on the surface to be exposed to plasma.

(Supplementary description 9)

According to further another aspect of the present disclosure, there is provided a sputtering target material comprising a sintered ceramics of a perovskite-type alkali niobium oxide containing potassium, sodium, niobium, and oxygen,
wherein a piezoelectric film is obtained, having a half-value width of an X-ray rocking curve of (001) within a range of 0.5° or more and 2.5° or less over an entire area of an inside of a main surface of the piezoelectric film excluding its periphery when performing X-ray diffraction measurement on the piezoelectric film, by being deposited on a substrate with a diameter of 3 inches or more, using the sputtering target material as a target material that is used when performing a deposition treatment by a sputtering method.

(Supplementary description 10)

Preferably, there is provided the target material according to the supplementary description 8 or 9, the target material containing at least one element selected from a group consisting of Li, Mg, Ca, Sr, Ba, Bi, Sb, V, In, Ta, Mo, W, Cr, Ti, Zr, Hf, Sc, Y, La, Ce, Pr, Nd, Sm, Eu, Gd, Tb, Dy, Ho, Er, Tm, Yb, Lu, Cu, Zn, Ag, Mn, Fe, Co, Ni, Al, Si, Ge, Sn, and Ga, as a dopant.

(Supplementary description 11)

Preferably, there is provided the target material according to any one of the supplementary descriptions 8 to 10, wherein there is no region where crystal grains with a grain size exceeding 30 $\mu$m are densely packed is observed in an entire area of the surface to be exposed to plasma, and in an entire area of any arbitrary surface parallel to this surface, when performing a deposition treatment using a sputtering method.
That is, an entire area of the surface to be exposed to plasma and an entire area of any arbitrary surface parallel to this surface when performing a deposition treatment using a sputtering method, comprise crystal grains with a grain size of 0.1 $\mu$m or more and 30 $\mu$m or less, preferably 0.1 $\mu$m or more and 20 $\mu$m or less, and more preferably 0.1 $\mu$m or more and 10 $\mu$m or less.

(Supplementary description 12)

Preferably, there is provided the target material according to any one of the supplementary descriptions 8 to 11, wherein a relative density is 60 % or more over an entire area of a surface to be exposed to plasma when performing a deposition treatment using a sputtering method.

(Supplementary description 13)

Preferably, there is provided the target material according to any one of the supplementary descriptions 8 to 12, wherein a flexural strength is 10 MPa or more over an entire area of a surface to be exposed to plasma when performing a deposition treatment using a sputtering method.

(Supplementary description 14)

Preferably, there is provided the target material according to any one of the supplementary descriptions 8 to 13, wherein a volume resistivity is 1000 kΩcm or more over an entire area of a surface to be exposed to plasma when performing a deposition treatment using a sputtering method.

(Supplementary description 15)

According to further another aspect of the present disclosure, there is provided a method of manufacturing a sputtering target material comprising a sintered ceramics of a perovskite-type alkali niobium oxide containing potassium, sodium, niobium, and oxygen, the method including:
obtaining a sputtering target material having a surface (a sputtering surface) to be exposed to plasma with a diameter of 3 inches or more by performing,

(a) obtaining a mixture by mixing powder comprising a potassium compound, powder comprising a sodium compound, and powder comprising a niobium compound, at a predetermined ratio;
(b) molding the mixture by applying a predetermined pressure, to obtain a molding with a diameter of 3 inches or more; and
(c) obtaining a sintered ceramics by heating and sintering the molding for 1 hour or more and 5 hours or less under a condition where a temperature within a front surface, which is a surface to be exposed to plasma (the surface to be sputtered) when performing a deposition treatment using a sputtering method, is 800 °C or higher and 1150 °C or lower over an entire front surface, and under a condition where a temperature gradient increases from the front surface to a rear surface, which is a surface opposite to the front surface, at a rate of 10 °C/mm or more.

(Supplementary description 16)

According to further another aspect of the present disclosure, there is provided a method of manufacturing a sputtering target material comprising a sintered ceramics of a perovskite-type alkali niobium oxide containing potassium, sodium, niobium, and oxygen, the method including:
obtaining a sputtering target material having a surface (a sputtering surface) to be exposed to plasma with a diameter of 3 inches or more by performing,

(a) obtaining a mixture by mixing powder comprising a compound containing potassium and niobium, and powder comprising a compound containing sodium and niobium, at a predetermined ratio;
(b) molding the mixture by applying a predetermined pressure, to obtain a molding with a diameter of 3 inches or more; and
(c) obtaining a sintered ceramics by heating and sintering the molding for 1 hour or more and 5 hours or less under a condition where a temperature within a front surface, which is a surface to be exposed to plasma (the surface to be sputtered), is 800 °C or higher and 1150 °C or lower over an entire surface, and under a condition where a temperature gradient increases from the front surface to a rear surface, which is a surface opposite to the front surface, at a rate of 10 °C/mm or more, when performing a deposition treatment using a sputtering method.

(Supplementary description 17)

Preferably, there is provided in the method according to the supplementary description 15 or 16, wherein (b) and (c) are performed at the same time. That is, (b) is performed while (c) is performed.

(Supplementary description 18)

Preferably, there is provided the method according to any one of the supplementary descriptions 15 to 17, the method further including after (a) and before (b):

(d) heating and pre-sintering the mixture at a temperature lower than a heating temperature of the molding in (c); and
(e) pulverizing the mixture after pre-sintering,
wherein, in (b), the mixture, which is pulverized after pre-sintering, is molded by applying a predetermined pressure, to obtain the molding.

(Supplementary description 19)

Preferably, there is provided the method according to any one of the supplementary descriptions 15 to 18, the method further including after (c),

(f) heating the sintered ceramics at a predetermined temperature.

DESCRIPTION OF SIGNS AND NUMERALS

| 1 | Substrate |
|---|---|
| 3 | Piezoelectric film (KNN-film) |
| 10 | Piezoelectric stack |
| 100 | Target material |
| 101 | Sputtering surface |

The present invention is summarized by the following preferred embodiments:

1. A piezoelectric stack comprising:

a substrate having a main surface with a diameter of 3 inches or more; and
a piezoelectric film on the substrate, comprising a perovskite-type alkali niobium oxide containing potassium, sodium, niobium, and oxygen,
wherein a half-value width of an X-ray rocking curve of (001) is within a range of 0.5° or more and 2.5° or less over an entire area of an inside of a main surface of the piezoelectric film excluding its periphery when performing X-ray diffraction measurement on the piezoelectric film.

2. The piezoelectric stack according to item 1,
wherein the piezoelectric film contains at least one element selected from a group consisting of Li, Mg, Ca, Sr, Ba, Bi, Sb, V, In, Ta, Mo, W, Cr, Ti, Zr, Hf, Sc, Y, La, Ce, Pr, Nd, Sm, Lu, Gd, Tb, Dy, Ho, Er, Tm, Yb, Lu, Cu, Zn, Ag, Mn, Fe, Co, Ni, Al, Si, Ge, Sn, and Ga, as a dopant.

3. A method of manufacturing a piezoelectric stack, comprising:

preparing a sputtering target material comprising a sintered ceramics of a perovskite-type alkali niobium oxide containing potassium, sodium, niobium, and oxygen;
preparing a substrate having a main surface with a diameter of 3 inches or more; and
depositing a piezoelectric film on the substrate using the sputtering target material, the piezoelectric film comprising the alkali niobium oxide, and having a half-value width of an X-ray rocking curve of (001) within a range of 0.5° or more and 2.5° or less over an entire area of an inside of a main surface of the piezoelectric film excluding its periphery when performing X-ray diffraction measurement on the piezoelectric film.

4. A sputtering target material comprising a sintered ceramics of a perovskite-type alkali niobium oxide containing potassium, sodium, niobium, and oxygen,
having 3 inches or more diameter of a surface to be exposed to plasma when performing a deposition treatment using a sputtering method, and
diffraction peak intensity from (001) within a range of 0.3 or more and 5 or less over an entire area of an inside of the surface to be exposed to plasma excluding its periphery when performing X-ray diffraction measurement on the surface to be exposed to plasma.

5. A sputtering target material comprising a sintered ceramics of a perovskite-type alkali niobium oxide containing potassium, sodium, niobium, and oxygen,
wherein a piezoelectric film is obtained, having a half-value width of an X-ray rocking curve of (001) within a range of 0.5° or more and 2.5° or less over an entire area of an inside of a main surface of the piezoelectric film excluding its periphery when performing X-ray diffraction measurement on the piezoelectric film, by being deposited a piezoelectric film on a substrate with a diameter of 3 inches or more, using the sputtering target material as a target material that is used when performing a deposition treatment by a sputtering method.

6. A method of manufacturing a sputtering target material comprising a sintered ceramics of a perovskite-type alkali niobium oxide containing potassium, sodium, niobium, and oxygen, the method comprising:
obtaining a sputtering target material having a surface to be exposed to plasma with a diameter of 3 inches or more by performing,

(a) obtaining a mixture by mixing powder comprising a potassium compound, powder comprising a sodium compound, and powder comprising a niobium compound, at a predetermined ratio;
(b) molding the mixture by applying a predetermined pressure, to obtain a molding with a diameter of 3 inches or more; and
(c) obtaining a sintered ceramics by sintering the molding for 1 hour or more and 5 hours or less under a condition where a temperature within a front surface, which is a surface to be exposed to plasma when performing a deposition treatment using a sputtering method, is 800 °C or higher and 1150 °C or lower over an entire front surface, and under a condition where a temperature gradient increases from the front surface to a rear surface, which is a surface opposite to the front surface, at a rate of 10 °C/mm or more.

7. The method of manufacturing a sputtering target material according to item 6,
wherein (b) and (c) are performed at the same time.

8. The method of manufacturing a sputtering target material according to item 6 or 7, the method further comprising after (a) and before (b):

(d) heating and pre-sintering the mixture at a temperature lower than a heating temperature of the molding in (c); and
(e) pulverizing the mixture after pre-sintering,
wherein, in (b), the mixture, which is pulverized after pre-sintering, is molded by applying a predetermined pressure, to obtain the molding.

## Claims

1. A piezoelectric stack comprising:

a substrate having a main surface with a diameter of 3 inches or more; and
a piezoelectric film on the substrate, comprising a perovskite-type alkali niobium oxide containing potassium, sodium, niobium, and oxygen,
wherein a half-value width of an X-ray rocking curve of (001) is within a range of 0.5° or more and 2.5° or less over an entire area of an inside of a main surface of the piezoelectric film excluding its periphery when performing X-ray diffraction measurement on the piezoelectric film.

2. The piezoelectric stack according to claim 1,
wherein the piezoelectric film contains at least one element selected from a group consisting of Li, Mg, Ca, Sr, Ba, Bi, Sb, V, In, Ta, Mo, W, Cr, Ti, Zr, Hf, Sc, Y, La, Ce, Pr, Nd, Sm, Eu, Gd, Tb, Dy, Ho, Er, Tm, Yb, Lu, Cu, Zn, Ag, Mn, Fe, Co, Ni, Al, Si, Ge, Sn, and Ga, as a dopant.

3. The piezoelectric stack according to claim 1 or 2,
wherein a (001) orientation percentage of crystals constituting the piezoelectric film is 80 % or more.

4. A method of manufacturing a piezoelectric stack, comprising:

preparing a sputtering target material comprising a sintered ceramics of a perovskite-type alkali niobium oxide containing potassium, sodium, niobium, and oxygen;
preparing a substrate having a main surface with a diameter of 3 inches or more; and
depositing a piezoelectric film on the substrate using the sputtering target material, the piezoelectric film comprising the alkali niobium oxide, and having a half-value width of an X-ray rocking curve of (001) within a range of 0.5° or more and 2.5° or less over an entire area of an inside of a main surface of the piezoelectric film excluding its periphery when performing X-ray diffraction measurement on the piezoelectric film.

5. The method of manufacturing a piezoelectric stack according to claim 4, wherein the sputtering target material has a ratio of an X-ray diffraction peak intensity from (110) with respect to an X-ray diffraction peak intensity from (001) within a range of 0.3 or more and 5 or less over an entire area of an inside of a surface to be exposed plasma excluding its periphery when performing X-ray diffraction measurement on the surface to be exposed plasma during the deposition of the piezoelectric film.

## FIG. 1

## FIG. 2

# FIG. 3

# FIG. 4

FIG. 5

100

101

## FIG. 6

**FIG. 7**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011146623 A